(19) Europäisches Patentamt / European Patent Office / Office européen des brevets

(11) **EP 3 252 774 B1**

(12) **FASCICULE DE BREVET EUROPEEN**

(45) Date de publication et mention
de la délivrance du brevet:
**30.01.2019 Bulletin 2019/05**

(51) Int Cl.:
*G11C 7/10* (2006.01)    *G11C 11/417* (2006.01)

(21) Numéro de dépôt: **17172088.1**

(22) Date de dépôt: **19.05.2017**

(54) **CIRCUIT MÉMOIRE ADAPTÉ À METTRE EN OEUVRE DES OPÉRATIONS DE CALCUL**

ADAPTIERTER SPEICHERSCHALTKREIS ZUR DURCHFÜHRUNG VON RECHENOPERATIONEN

MEMORY CIRCUIT SUITABLE FOR PERFORMING COMPUTING OPERATIONS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **24.05.2016 FR 1654623**

(43) Date de publication de la demande:
**06.12.2017 Bulletin 2017/49**

(73) Titulaire: **Commissariat à l'Energie Atomique et
aux Energies
Alternatives
75015 Paris (FR)**

(72) Inventeurs:
• **NOEL, Jean-Philippe**
**38330 Montbonnot Saint Martin (FR)**
• **AKYEL, Kaya Can**
**38000 Grenoble (FR)**

(74) Mandataire: **Cabinet Beaumont
4, Place Robert Schuman
B.P. 1529
38025 Grenoble Cedex 1 (FR)**

(56) Documents cités:
**US-A- 5 365 480     US-A1- 2009 141 537
US-A1- 2016 125 919**

• JELOKA SUPREET ET AL: "A 28 nm Configurable
Memory (TCAM/BCAM/SRAM) Using Push-Rule
6T Bit Cell Enabling Logic-in-Memory", IEEE
JOURNAL OF SOLID-STATE CIRCUITS, IEEE
SERVICE CENTER, PISCATAWAY, NJ, USA, vol.
51, no. 4, 1 avril 2016 (2016-04-01), pages
1009-1021, XP011605236, ISSN: 0018-9200, DOI:
10.1109/JSSC.2016.2515510 [extrait le
2016-04-04]
• KAZUTOSHI KOBAYASHI ET AL: "A
BIT-PARALLEL BLOCK-PARALLEL
FUNCTIONAL MEMORY TYPE PARALLEL
PROCESOR LSI FOR FAST ADDITION AND
MULTIPLICATION", 1995 SYMPOSIUM ON VLSI
CIRCUITS. KYOTO, JUNE 8 - 10, 1995;
[SYMPOSIUM ON VLSI CIRCUITS], NEW YORK,
IEEE, US, 8 juin 1995 (1995-06-08), page 61/62,
XP000557801, ISBN: 978-0-7803-2600-2

## Description

<u>Domaine</u>

La présente demande concerne le domaine des circuits de calcul numérique.

<u>Exposé de l'art antérieur</u>

De façon classique, un circuit de calcul numérique, par exemple un microprocesseur, comprend une mémoire interne (banc de registres, mémoire cache, etc.), et une unité arithmétique et logique (ALU) adaptée à mettre en oeuvre des opérations arithmétiques et/ou logiques de base pour traiter des données contenues dans la mémoire interne du circuit.

Une limitation à l'augmentation de la vitesse de fonctionnement des circuits de calcul numérique est liée à la vitesse de fonctionnement de la mémoire interne, qui ne suit pas la même augmentation que celle de l'unité arithmétique et logique.

Une autre limitation des architectures existantes est liée à la longueur importante des pistes conductrices de routage reliant la mémoire interne à l'unité arithmétique et logique, qui entraine une consommation d'énergie significative et une dissipation thermique élevée à chaque transfert de donnée entre la mémoire interne et l'unité arithmétique et logique.

Une autre architecture possible consiste à traiter les données directement dans la mémoire interne comme le montre les documents US 2009/141537 et US 2016/125919.

<u>Résumé</u>

L'invention est définie par le circuit des revendications 1 à 17. Un mode de réalisation prévoit un circuit mémoire adapté à mettre en oeuvre des opérations de calcul, ce circuit comportant :

une pluralité de cellules mémoires élémentaires agencées selon des lignes et des colonnes, chaque cellule comportant :

- un premier noeud de stockage d'un bit de donnée,
- un premier transistor de lecture relié par sa grille audit premier noeud de stockage, et
- un premier transistor de sélection monté en série avec le premier transistor de lecture entre un premier noeud d'application d'un potentiel de référence de la cellule et une première piste conductrice de sortie commune à toutes les cellules d'une même colonne du circuit ;

et un circuit de contrôle configuré pour activer simultanément les premiers transistors de sélection d'au moins deux cellules d'une même colonne du circuit, et pour lire sur la première piste conductrice de sortie de la colonne une valeur représentative du résultat d'une première opération logique ayant pour opérandes les données stockées dans lesdites au moins deux cellules.

Selon un mode de réalisation, le circuit mémoire comporte en outre, pour chaque colonne du circuit, un premier inverseur dont un noeud d'entrée est relié à la première piste conductrice de sortie de la colonne.

Selon un mode de réalisation, chaque cellule élémentaire comporte en outre :

- un deuxième noeud de stockage d'un bit de donnée complémentaire du bit stocké sur le premier noeud de stockage de la cellule,
- un deuxième transistor de lecture relié par sa grille audit deuxième noeud de stockage, et
- un deuxième transistor de sélection monté en série avec le deuxième transistor de lecture entre un deuxième noeud d'application d'un potentiel de référence de la cellule et une deuxième piste conductrice de sortie commune à toutes les cellules d'une même colonne du circuit,

le circuit de contrôle étant en outre configuré pour activer simultanément les deuxièmes transistors de sélection d'au moins deux cellules d'une même colonne du circuit, et à lire sur la deuxième piste conductrice de sortie de la colonne une valeur représentative du résultat d'une deuxième opération logique ayant pour opérandes les données stockées dans lesdites au moins deux cellules.

Selon un mode de réalisation, le circuit de contrôle est en outre configuré pour activer simultanément :

les premiers et deuxièmes transistors de sélection de deux cellules d'une même colonne du circuit ; ou le premier transistor de sélection d'une première cellule du circuit et le deuxième transistor de sélection d'une deuxième cellule de la même colonne.

Selon un mode de réalisation, le circuit mémoire comporte en outre, pour chaque colonne du circuit, un deuxième inverseur dont un noeud d'entrée est relié à la deuxième piste conductrice de sortie de la colonne.

Selon un mode de réalisation, le circuit mémoire comporte en outre, pour chaque colonne du circuit, une porte logique NON OU dont une première entrée est reliée à la première piste conductrice de sortie de la colonne et dont une deuxième entrée est reliée à la deuxième piste conductrice de sortie de la colonne.

Selon un mode de réalisation, le circuit mémoire comporte en outre, pour chaque colonne du circuit, une première porte logique NON ET dont une première entrée est reliée à un noeud de sortie de la porte logique NON OU de la colonne, et une deuxième porte logique NON ET dont une première entrée est reliée à un noeud de sortie de la première porte logique NON ET de la colonne et dont une deuxième entrée est reliée à la deuxième piste conductrice de sortie de la colonne.

Selon un mode de réalisation, dans chaque colonne à l'exception de la première colonne du circuit, la première porte logique NON ET a une deuxième entrée reliée à la deuxième piste conductrice de sortie d'une colonne de rang précédent du circuit.

Selon un mode de réalisation, le circuit mémoire comporte en outre, pour chaque colonne : une première piste conductrice de référence interconnectant les premiers noeuds d'application de potentiel de référence de la colonne ; et une deuxième piste conductrice de référence interconnectant les deuxièmes noeuds d'application de potentiel de référence de la colonne.

Selon un mode de réalisation, le circuit mémoire comporte en outre, pour chaque colonne : un premier transistor de référence reliant la première piste conductrice de référence à un noeud de référence ; et un deuxième transistor de référence reliant la deuxième piste conductrice de référence audit noeud de référence.

Selon un mode de réalisation, le circuit mémoire comporte en outre, pour chaque colonne, une porte logique ET, une porte logique OU, et des troisième, quatrième, cinquième et sixième inverseurs, et : la porte logique ET a une première entrée reliée à un noeud d'application d'un premier signal binaire de contrôle par l'intermédiaire du troisième inverseur, et une deuxième entrée reliée à un noeud d'application d'un deuxième signal binaire de contrôle par l'intermédiaire du quatrième inverseur ; la sortie du troisième inverseur est reliée à la première piste conductrice de référence de la colonne par l'intermédiaire du cinquième inverseur ; la porte logique OU a une première entrée reliée à la première piste conductrice de sortie de la colonne, et une deuxième entrée reliée à la sortie de la porte logique ET ; et la sortie de la porte logique OU est reliée à la deuxième piste conductrice de référence de la colonne par l'intermédiaire du sixième inverseur.

Selon un mode de réalisation, le circuit mémoire comporte en outre, pour chaque colonne du circuit : un premier multiplexeur ayant une première entrée reliée à l'entrée du premier inverseur et une deuxième entrée reliée à la sortie du premier inverseur ; un troisième inverseur dont l'entrée est reliée à la sortie du premier multiplexeur ; une troisième porte NON ET dont une première entrée est reliée à la sortie du premier multiplexeur et dont une deuxième entrée est reliée à l'entrée du deuxième inverseur ; une quatrième porte NON ET dont une première entrée est reliée à la sortie du troisième inverseur et dont une deuxième entrée est reliée à la sortie du deuxième inverseur ; et une cinquième porte NON ET dont une première entrée est reliée à la sortie de la troisième porte NON ET et dont la sortie est reliée à la sortie de la quatrième porte NON ET.

Selon un mode de réalisation, les cellules mémoires élémentaires sont des cellules mémoires volatiles de type SRAM.

Selon un mode de réalisation, les cellules mémoires élémentaires sont des cellules mémoires résistives non volatiles.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 est un schéma électrique d'un exemple d'un circuit mémoire selon un mode de réalisation ;
la figure 2 représente de façon schématique un exemple d'un circuit mémoire selon un mode de réalisation ;
la figure 3 représente de façon schématique une variante de réalisation du circuit mémoire de la figure 2 ;
la figure 4 représente de façon schématique une autre variante d'un circuit mémoire selon un mode de réalisation ;
la figure 5 représente de façon schématique un autre exemple d'un circuit mémoire selon un mode de réalisation ;
la figure 6 représente de façon schématique une variante de réalisation du circuit mémoire de la figure 5 ;
la figure 7 représente de façon schématique une autre variante de réalisation du circuit mémoire de la figure 5 ;
la figure 8 est un schéma électrique d'un autre exemple d'une cellule élémentaire d'un circuit mémoire selon un mode de réalisation ; et
la figure 9 est un chronogramme illustrant un exemple de fonctionnement du circuit mémoire de la figure 2.

Description détaillée

De mêmes éléments ont été désignés par de mêmes références aux différentes figures. Par souci de clarté, seuls les éléments qui sont utiles à la compréhension des modes de réalisation décrits ont été représentés et sont détaillés. Dans la description qui suit, les références à des signaux de niveau haut et bas doivent être interprétées de façon relative, comme correspondant à deux états distincts des signaux binaires traités par les circuits décrits. A titre d'exemple, les signaux de niveau haut correspondent à des potentiels de l'ordre d'un potentiel d'alimentation haut VDD des circuits décrits (par exemple égal à VDD à 0,5 V près), et les signaux de niveau bas correspondent à des potentiels de l'ordre d'un potentiel d'alimentation bas GND des circuits décrits (par exemple égal à GND à 0,5 V près).

Selon un aspect des modes de réalisation décrits, on prévoit un circuit mémoire adapté non seulement à stocker des données, mais aussi à effectuer, in-situ, lors d'accès au contenu de la mémoire, un certain nombre d'opérations logiques et/ou arithmétiques ayant pour opérandes des données stockées dans le circuit. Les résultats des calculs peuvent être transmis à des circuits externes à la mémoire, et/ou être réécrits dans la mémoire.

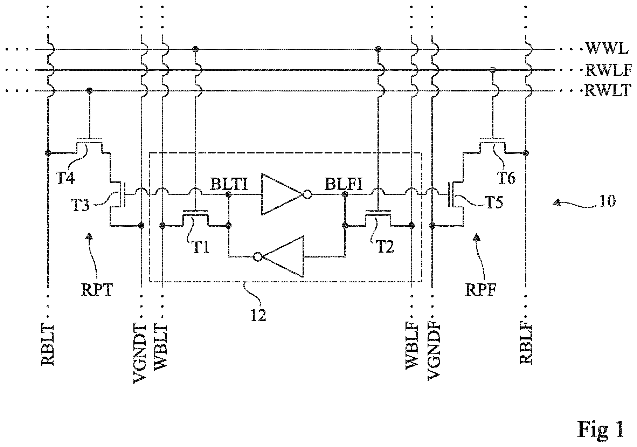

La figure 1 est un schéma électrique d'un exemple d'une cellule élémentaire 10 d'un circuit mémoire selon un mode de réalisation.

La cellule élémentaire 10 de la figure 1 est une cellule à dix transistors. Elle comprend une cellule de stockage SRAM 12 à six transistors, et deux ports de lecture RPT et RPF à deux transistors chacun. La cellule de stockage 12 comprend deux inverseurs (deux transistors chacun) montés en antiparallèle entre un premier noeud BLTI de stockage d'un bit de donnée, et un deuxième noeud BLFI de stockage d'un bit de donnée complémentaire du bit stocké sur le noeud BLTI. La cellule de stockage 12 comprend en outre un premier transistor d'accès en écriture T1, reliant par ses noeuds de conduction le noeud BLTI à une piste conductrice d'écriture WBLT, et un deuxième transistor d'accès en écriture T2, reliant par ses noeuds de conduction le noeud BLFI à une piste conductrice d'écriture WBLF. Les grilles des transistors T1 et T2 sont reliées à une même piste conductrice de contrôle d'écriture WWL. Le port de lecture RPT comprend deux transistors T3 et T4 montés en série via leurs noeuds de conduction entre une piste conductrice VGNDT d'application d'un potentiel de référence et une piste conductrice de sortie RBLT. Le transistor T3 est situé côté piste VGNDT et a sa grille reliée au noeud BLTI, et le transistor T4 est situé côté piste RBLT et a sa grille reliée à une piste conductrice de contrôle de lecture RWLT. Le port de lecture RPF comprend deux transistors T5 et T6 montés en série via leurs noeuds de conduction entre une piste conductrice VGNDF d'application d'un potentiel de référence et une piste conductrice de sortie RBLF. Le transistor T5 est situé côté piste VGNDF et a sa grille reliée au noeud BLFI, et le transistor T6 est situé côté piste RBLF et a sa grille reliée à une piste conductrice de contrôle de lecture RWLF. Dans cet exemple, les transistors T1, T2, T3, T4, T5, T6 sont des transistors MOS à canal N.

Un circuit mémoire selon un mode de réalisation comprend une pluralité de cellules élémentaires 10 du type décrit en relation avec la figure 1, identiques ou similaires, agencées en matrice selon des lignes et des colonnes. Les cellules d'une même ligne sont interconnectées via leurs pistes conductrices WWL, respectivement RWLF, respectivement RWLT, et les cellules d'une même colonne sont interconnectées via leurs pistes conductrices RBLT, respectivement VGNDT, respectivement WBLT, respectivement WBLF, respectivement VGNDF, respectivement RBLF. En d'autres termes, les cellules d'une même ligne partagent une même piste conductrice WWL, une même piste conductrice RWLF, et une même piste conductrice RWLT, et les cellules d'une même colonne partagent une même piste conductrice RBLT, une même piste conductrice VGNDT, une même piste conductrice WBLT, une même piste conductrice WBLF, une même piste conductrice VGNDF, et une même piste conductrice RBLF. Les cellules de lignes distinctes ont quant à elles des pistes conductrices WWL, respectivement RWLF, respectivement RWLT, distinctes, et les cellules de colonnes distinctes ont des pistes conductrices RBLT, respectivement VGNDT, respectivement WBLT, respectivement WBLF, respectivement VGNDF, respectivement RBLF, distinctes.

Pour réaliser une lecture d'une cellule élémentaire 10 de la mémoire via son port de lecture RPT, la piste conductrice de sortie RBLT de la cellule est préchargée à un niveau haut, par exemple à la tension d'alimentation VDD du circuit. La piste conductrice VGNDT est quant à elle maintenue à un niveau bas, par exemple au potentiel bas GND par rapport auquel est référencée la tension d'alimentation VDD du circuit. Le transistor T4 de la cellule est ensuite rendu passant par application d'un signal de niveau haut sur la piste conductrice RWLT de la cellule. Après l'activation du transistor T4, la piste conductrice RBLT se décharge si le potentiel du noeud BLTI est à un niveau haut (transistor T3 passant), et reste sensiblement à son niveau de précharge si le potentiel BLTI est à un niveau bas (transistor T3 bloqué). La lecture du potentiel de la piste RBLT via un circuit de lecture non représenté, par exemple disposé en pied de colonne, permet de déterminer la valeur du bit de donnée stocké dans la cellule élémentaire. La cellule peut en outre être lue sensiblement de la même manière via son port de lecture RPF.

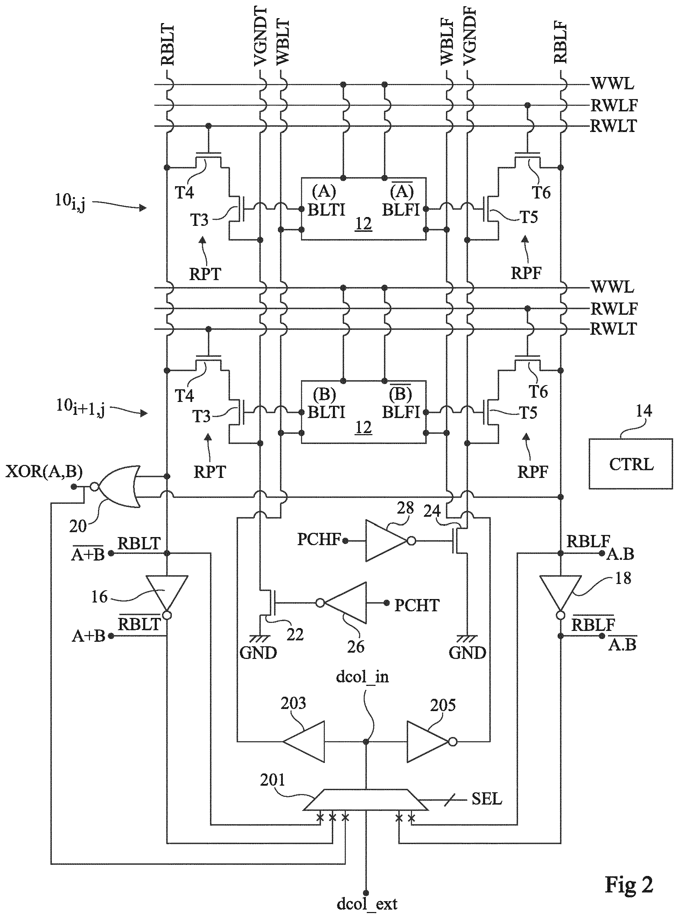

La figure 2 représente de façon schématique un exemple d'un mode de réalisation d'un circuit mémoire adapté à mettre en oeuvre des opérations de calcul. Par souci de simplification, seules deux cellules élémentaires $10_{i,j}$ et $10_{i+1,j}$ d'une même colonne du circuit mémoire ont été représentées sur la figure 2, i et j étant des indices désignant respectivement le rang de la ligne à laquelle appartient la cellule et le rang de la colonne à laquelle appartient la cellule, avec i entier allant de 1 à M et j entier allant de 1 à N, M et N étant des entiers désignant respectivement le nombre de lignes et le nombre de colonnes du circuit mémoire. De plus, les cellules de stockage 12 des cellules élémentaires n'ont pas été détaillées sur la figure 2.

Le circuit mémoire de la figure 2 comprend un circuit de contrôle 14 (CTRL). Le circuit de contrôle 14 est adapté à commander le circuit mémoire pour mettre en oeuvre des opérations de lecture classiques du type décrit en relation avec la figure 1, ou pour mettre en oeuvre des opérations d'écriture via les pistes conductrices d'accès en écriture WBLT, WBLF, et WWL des cellules.

Selon un aspect d'un mode de réalisation, le circuit de contrôle 14 est en outre adapté à commander le circuit mémoire pour mettre en oeuvre des opérations de calcul. Pour cela, le circuit de contrôle 14 est adapté à activer simultanément en lecture deux, ou un nombre supérieur à deux, de cellules élémentaires d'une même colonne du circuit, via les ports d'accès RPT, et/ou via les ports d'accès RPF de ces cellules.

A titre d'exemple illustratif, on considère que les deux cellules $10_{i,j}$ et $10_{i+1,j}$ représentées en figure 2 sont activées simultanément en lecture via leurs ports RPT et RPF. Pour cela, après avoir préchargé à un niveau haut les pistes conductrices de sortie RBLT et RBLF de la colonne et mis à un niveau bas les pistes conductrices de référence VGNDT et VGNDF de la colonne, les transistors de sélection T4 et T6 des deux cellules $10_{i,j}$ et $10_{i+1,j}$ sont simultanément rendus passant par le circuit de contrôle 14, via les pistes conductrices de commande RWLT et RWLF des lignes $10_{i,j}$ et $10_{i+1,j}$. On désigne par A la valeur binaire mémorisée sur le noeud BLTI de la cellule $10_{i,j}$ et par B la valeur binaire mémorisée sur le noeud BLTI de la cellule $10_{i+1,j}$. La cellule $10_{i,j}$ stocke alors sur son noeud BLFI le complémentaire $\overline{A}$ de la valeur A, et la cellule $10_{i+1,j}$ stocke sur son noeud BLFI le complémentaire $\overline{B}$ de la valeur B. La piste conductrice de sortie RBLT de la colonne reste à son niveau haut de précharge uniquement si les deux valeurs A et B sont à un niveau bas. Ainsi, le niveau lu sur la piste de sortie RBLT de la colonne à la fin de l'opération de lecture correspond au résultat $\overline{A+B}$ d'une opération de calcul logique NON OU entre les deux cellules mémoires sélectionnées. De plus, la piste conductrice de sortie RBLF de la colonne reste à son niveau haut de précharge uniquement si les deux valeurs A et B sont à un niveau haut. Ainsi, le niveau lu sur la piste de sortie RBLF de la colonne à la fin de l'opération de lecture correspond au résultat A.B d'une opération de calcul logique ET entre les deux cellules mémoires sélectionnées.

Dans l'exemple de la figure 2, le circuit mémoire comprend en outre, pour chaque colonne de la matrice, par exemple disposé en pied de colonne, un inverseur 16 dont l'entrée est reliée à la piste conductrice de sortie RBLT de la colonne, et un inverseur 18 dont l'entrée est reliée à la piste conductrice de sortie RBLF de la colonne. Ainsi, à la fin d'une opération de lecture du type décrit ci-dessus, le niveau lu sur le noeud de sortie $\overline{RBLT}$ de l'inverseur 16 correspond au résultat A+B d'une opération de calcul logique OU entre les deux cellules mémoires sélectionnées, et le niveau lu sur le noeud de sortie $\overline{RBLF}$ de l'inverseur 18 correspond au résultat $\overline{A.B}$ d'une opération de calcul logique NON ET entre les deux cellules mémoires sélectionnées.

Par ailleurs, dans l'exemple de la figure 2, le circuit mémoire comprend en outre, pour chaque colonne de la matrice, par exemple disposé en pied de colonne, une porte logique NON OU 20 à deux entrées et une sortie, les entrées de la porte 20 étant reliées respectivement à la piste RBLT et à la piste RBLF. A la fin d'une opération de lecture du type décrit ci-dessus, le niveau lu en sortie de la porte 20 correspond au résultat d'une opération de calcul logique NON OU entre les valeurs $\overline{A+B}$ et A.B, c'est-à-dire au résultat XOR(A,B) d'une opération de calcul logique OU EXCLUSIF entre les deux cellules mémoires sélectionnées.

En activant simultanément en lecture un nombre supérieur à deux de cellules d'une même colonne, les opérations logiques susmentionnées peuvent être mises en oeuvre avec un nombre d'opérandes supérieur à 2. De plus, en activant simultanément en lecture plusieurs colonnes du circuit, ces opérations logiques peuvent être mises en oeuvre sur des mots de plusieurs bits.

Un avantage du circuit mémoire de la figure 2 est qu'il permet de mettre en oeuvre des opérations logiques de base directement dans la mémoire, sans avoir à faire transiter les données par une unité arithmétique et logique externe au circuit.

Ceci permet de réduire la consommation et la dissipation d'énergie électrique liées au transfert des données entre la mémoire et l'unité arithmétique et logique.

En outre, ceci permet d'augmenter la vitesse d'exécution des calculs. En effet, dans une architecture classique comportant une unité arithmétique et logique externe à la mémoire, l'exécution d'une opération de calcul logique à K opérandes, avec K entier supérieur ou égal à 2, comprend, outre les étapes de calcul proprement dites, K étapes de lecture successives dans la mémoire pour lire les K opérandes à traiter, et une étape éventuelle de réécriture du résultat de l'opération dans la mémoire. Dans le mode de réalisation de la figure 2, l'exécution d'une opération de calcul logique à K opérandes peut être réalisée dans un temps aussi court que le temps nécessaire à la mise en oeuvre d'un cycle de lecture unique dans la mémoire. Le résultat de l'opération peut être lu en sortie de la mémoire, et/ou réécrit dans la mémoire lors d'une opération d'écriture subséquente.

On notera de plus que dans le mode de réalisation de la figure 2, plusieurs opérations logiques de natures différentes peuvent être réalisées en parallèle sur une même colonne de la mémoire (les opérations OU, NON OU, ET, NON ET et OU EXCLUSIF dans l'exemple décrit ci-dessus).

Dans l'exemple de la figure 2, dans chaque colonne du circuit mémoire, la piste conductrice VGNDT de la colonne est reliée à la masse (GND) par l'intermédiaire d'un transistor 22, et la piste conductrice VGNDF est reliée à la masse (GND) par l'intermédiaire d'un transistor 24. Le transistor 22 a sa grille reliée à un noeud de commande PCHT par l'intermédiaire d'un inverseur 26, et le transistor 24 a sa grille reliée à un noeud de commande PCHF par l'intermédiaire d'un inverseur 28. Dans cet exemple, les transistors 22 et 24 sont des transistors MOS à canal N. Les noeuds PCHT et PCHF sont mis à un niveau bas par le circuit de contrôle 14 lors des opérations de lecture et/ou de calcul logique de façon à ramener les pistes conductrices VGNDT et VGNDF à un niveau bas et permettre, le cas échéant (en fonction des valeurs des données contenues dans les cellules sélectionnées), la décharge des pistes conductrices RBLT et RBLF. En dehors des opérations de lecture et/ou de calcul logique, les noeuds PCHT et PCHF sont maintenus à un niveau haut de façon à limiter les courants de fuite via les ports de lecture. En particulier, lorsqu'une ou plusieurs lignes sont activées lors d'une opération de lecture et/ou de calcul logique, les noeuds PCHT et PCHF des colonnes non sélectionnées pour l'opération sont maintenus à un niveau haut.

Pour permettre la réécriture du résultat d'une opération logique sans faire transiter la donnée calculée par des circuits externes à la mémoire, et notamment par un bus de données externe à la mémoire, le circuit mémoire de la figure 2 comprend en outre, pour chaque colonne de la matrice, par exemple disposé en pied de colonne, un circuit interne de redirection 201 permettant de relier au moins l'un des noeuds de sortie de la colonne, à savoir, dans cet exemple, les noeuds RBLT, RBLF, RBLT, RBLF et le noeud de sortie de la porte 20 et le noeud de sortie de la porte 20, à un noeud d'entrée de donnée dcol_in de la colonne. Dans l'exemple représenté, le circuit de redirection 201 est un multiplexeur de six entrées vers une sortie. Plus particulièrement, le multiplexeur 201 comprend cinq entrées reliées respectivement au noeud RBLT, au noeud RBLF, au noeud RBLT, au noeud RBLF et au noeud de sortie de la porte 20, et une sixième entrée reliée à un noeud dcol_ext d'application d'une donnée binaire provenant de l'extérieur de la mémoire (par exemple relié à un bus d'entrée de données externe au circuit mémoire). La sortie du multiplexeur est reliée au noeud d'entrée de donnée dcol_in de la colonne. Dans l'exemple représenté, le circuit mémoire comprend, pour chaque colonne de la matrice, un buffer 203 reliant le noeud dcol_in à la piste conductrice WBLT de la colonne et un inverseur 205 reliant le noeud dcol_in à la piste conductrice WBLF de la colonne, de façon à permettre d'écrire simultanément la donnée binaire appliquée sur le noeud dcol_in sur la piste WBLT et son complémentaire sur la piste WBLF. Le multiplexeur 201 reçoit un signal de commande SEL, par exemple fourni par le circuit de contrôle 14 de la mémoire, permettant, lors d'une opération d'écriture, de sélectionner la donnée à écrire dans la colonne. On notera que des bascules, représentées par des croix sur la figure 2, peuvent optionnellement être prévues entre chacun des noeuds de sortie de la colonne et le noeud d'entrée correspondant du multiplexeur 201, de façon à permettre une mémorisation de la donnée à écrire entre la fin de l'opération de lecture (qui peut comprendre une opération de calcul logique ayant pour opérandes les données lues) et l'opération d'écriture proprement dite de la donnée à une adresse fournie par le circuit de contrôle 14 de la mémoire. A titre de variante, le circuit de redirection 201 peut comprendre plusieurs sorties reliées à des noeuds d'entrée de donnée dcol_in de colonnes distinctes de la matrice, de façon que le circuit de contrôle 14 puisse sélectionner, par l'intermédiaire du signal de sélection SEL, une colonne de réécriture de la donnée calculée qui soit différente de la colonne dans laquelle le calcul a été effectué.

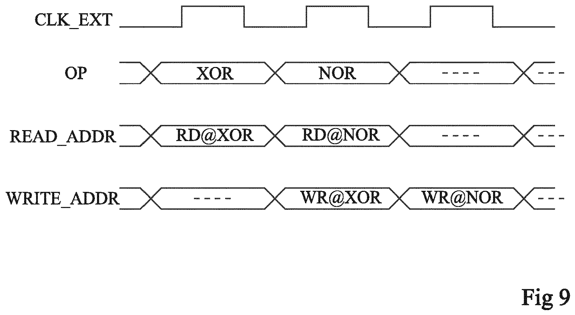

La figure 9 est un chronogramme illustrant un exemple de fonctionnement du circuit mémoire de la figure 2 lors d'une phase de mise en oeuvre d'opérations de calcul avec réécriture du résultat des opérations dans la mémoire, sans transit des données calculées par des circuits externes.

La figure 9 représente plus particulièrement l'évolution, en fonction du temps :

d'un signal d'horloge externe CLK_EXT fourni par un circuit extérieur et cadençant le fonctionnement du circuit mémoire ;

d'un signal externe de commande OP fourni par un circuit extérieur et indiquant au circuit mémoire le type d'opération à effectuer, ainsi que la ou les adresses concernées par l'opération ;

d'un signal d'adresse interne READ_ADDR généré par le circuit de contrôle 14 de la mémoire à partir du signal OP, correspondant à l'adresse ou aux adresses de lecture concernées par l'opération à effectuer, c'est-à-dire à l'adresse ou aux adresses des opérandes de l'opération ; et

d'un signal d'adresse interne WRITE ADDR généré par le circuit de contrôle 14 de la mémoire à partir du signal OP, correspondant à l'adresse de réécriture du résultat de l'opération.

Dans l'exemple représenté, la période $T_{CLK\_EXT}$ du signal d'horloge CLK_EXT est égale au temps de cycle de la mémoire, c'est-à-dire au temps nécessaire à la mise en oeuvre d'une opération de lecture ou d'écriture d'une donnée dans la mémoire. Autrement dit, une unique opération de lecture ou une unique opération d'écriture peut être mise en oeuvre pendant la période $T_{CLK\_EXT}$.

A chaque front montant du signal d'horloge CLK_EXT, le circuit de contrôle 14 de la mémoire échantillonne le signal OP, extrait du signal OP le signal READ_ADDR, et sélectionne en lecture les lignes correspondantes de la matrice, contenant les opérandes de l'opération à réaliser. Le circuit de contrôle 14 extrait en outre du signal OP le signal WRITE ADDR et le mémorise en vue de la réécriture ultérieure du résultat de l'opération dans la mémoire.

L'opération de calcul proprement dite est effectuée en un cycle d'horloge $T_{CLK\_EXT}$ comme cela a été expliqué précédemment.

Au front montant suivant du signal CLK_EXT, le signal OP est à nouveau échantillonné et une opération suivante peut démarrer. Simultanément, le circuit de contrôle 14 sélectionne en écriture la ligne correspondant au signal WRITE_ADDR mémorisé lors du cycle précédent, et commande le circuit de redirection 201, via le signal SEL, pour écrire dans cette ligne le résultat de l'opération réalisée au cycle précédent.

A titre de variante, la période $T_{CLK\_EXT}$ du signal CLK_EXT peut être supérieure au temps de cycle de la mémoire, par exemple égale à un multiple du temps de cycle de la mémoire. Dans ce cas, pendant une période du signal $T_{CLK\_EXT}$, plusieurs opérations de calcul (ou de lecture) et/ou d'écriture successives peuvent être réalisées. Le séquencement de ces opérations peut être réalisé de façon asynchrone au moyen d'une machine d'états interne au circuit mémoire. A titre de variante, le circuit mémoire peut comprendre un circuit de génération d'un signal d'horloge interne égal au temps de cycle de la mémoire, ce signal étant utilisé par le circuit de contrôle 14 pour séquencer les opérations de façon synchrone.

Dans les variantes de réalisation décrites ci-après, par souci de simplification, le circuit de redirection 201 permettant de réécrire directement dans la mémoire, sans transiter par des circuits ou bus externes, le résultat d'une opération effectuée à l'intérieur de la mémoire, n'a pas été détaillé ni représenté sur les figures.

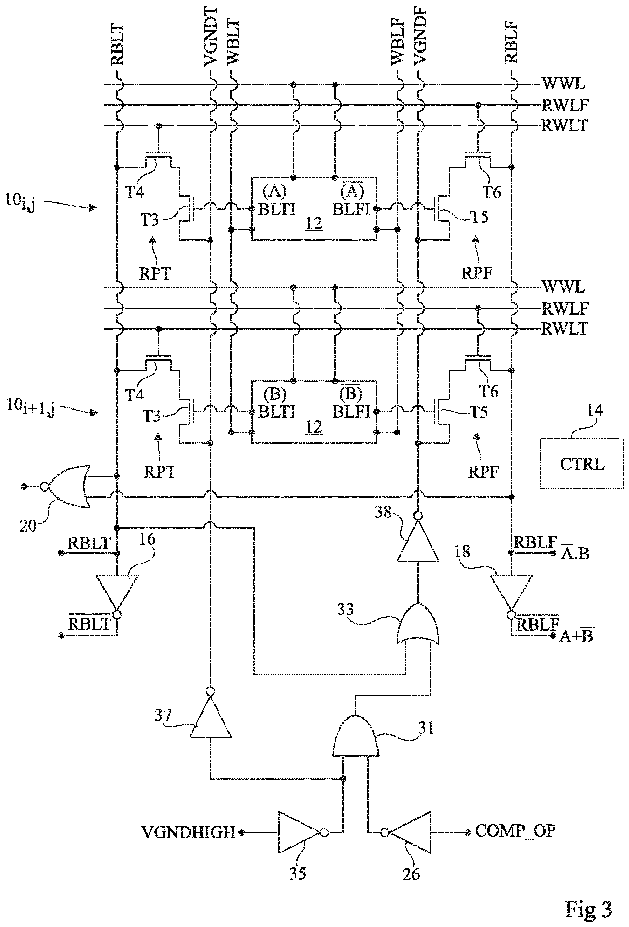

La figure 3 représente de façon schématique une variante de réalisation du circuit mémoire de la figure 2.

Le circuit mémoire de la figure 3 diffère du circuit mémoire de la figure 2 principalement en ce que, dans le circuit de la figure 3, dans chaque colonne de la matrice, les inverseurs 26 et 28 et les transistors 22 et 24 sont remplacés par d'autres éléments de contrôle des pistes conductrices de référence VGNDT et VGNDF de la colonne. Plus particulièrement, dans l'exemple de la figure 3, le circuit mémoire comprend, pour chaque colonne de la mémoire, une porte logique ET 31, une porte logique OU 33, et quatre inverseurs 35, 36, 37 et 38. La porte logique ET 31 a une première entrée reliée à un noeud d'application d'un premier signal binaire de contrôle VGNDHIGH par l'intermédiaire de l'inverseur 35, et une deuxième entrée reliée à un noeud d'application d'un deuxième signal binaire de contrôle COMP_OP par l'intermédiaire de l'inverseur 36. Ainsi, la porte logique ET reçoit, sur sa première entrée, le complémentaire $\overline{VGNDHIGH}$ du signal VGNDHIGH, et sur sa deuxième entrée, le complémentaire $\overline{COMP\_OP}$ du signal COMP_OP. La première entrée de la porte logique ET 31, ou sortie de l'inverseur 35, est en outre reliée à la piste conductrice de référence VGNDT de la colonne par l'intermédiaire de l'inverseur 37. Ainsi, la piste conductrice VGNDT est maintenue à un état haut lorsque le signal binaire VGNDHIGH est à l'état haut, et à un état bas lorsque le signal binaire VGNDHIGH est à l'état bas. La porte logique OU 33 a une première entrée reliée à la piste conductrice de sortie RBLT de la colonne, et une deuxième entrée reliée à la sortie de la porte logique ET 31. La sortie de la porte logique OU 33 est reliée à la piste conductrice de référence VGNDF de la colonne par l'intermédiaire de l'inverseur 38. Ainsi, la piste conductrice VGNDF est maintenue à un état haut lorsque la sortie de la porte logique OU 33 est à l'état bas, et à un état bas lorsque la sortie de la porte logique OU 33 est à l'état haut.

Le circuit mémoire de la figure 3 permet de réaliser les mêmes opérations logiques de base que le circuit de la figure 2. Pour cela, le circuit de contrôle 14 maintient les signaux VGNDHIGH et COMP_OP à l'état bas dans la ou les colonnes concernées par une opération de lecture ou de calcul logique. Il en résulte que les pistes conductrices de référence VGNDT et VGNDF de la ou des colonnes concernées par l'opération sont maintenues à un potentiel bas, ce qui permet, le cas échéant (en fonction des valeurs des données contenues dans les cellules sélectionnées), la décharge des pistes conductrices RBLT et RBLF.

Le circuit mémoire de la figure 3 permet en outre de réaliser des opérations logiques composées. Pour cela, le circuit 14 maintient les signaux VGNDHIGH et COMP_OP à l'état haut dans chaque colonne concernée par l'opération. Il en résulte que la piste conductrice de référence VGNDT de la colonne est maintenue à un potentiel haut. De plus, la sortie de la porte logique ET 31 est à l'état bas, de sorte que l'état, haut ou bas, de la sortie de la porte logique OU 33 est fixé par le niveau, haut ou bas, de la piste conductrice de sortie RBLT de la colonne. Ainsi, la piste conductrice de référence VGNDF de la colonne est maintenue à l'état bas lorsque la piste conductrice de sortie RBLT de la colonne est à l'état haut, et est maintenue à l'état haut lorsque la piste conductrice de sortie RBLT de la colonne est à l'état bas.

Le circuit de contrôle 14 active ensuite simultanément en lecture deux cellules élémentaires de la colonne, les cellules $10_{i,j}$ et $10_{i+1,j}$ dans l'exemple représenté. L'une des deux cellules, la cellule $10_{i,j}$ dans cet exemple, est activée via son port de lecture RPT, le circuit de contrôle 14 maintenant le port de lecture RPF de cette cellule bloqué. L'autre cellule, la cellule $10_{i+1,j}$ dans cet exemple, est activée via son port de lecture RPF, le circuit de contrôle 14 maintenant le port de lecture RRT de cette cellule bloqué.

Suite à l'activation du port de lecture RPT de la cellule $1_{0i,j}$, la piste conductrice de sortie RBLT de la colonne est à un état correspondant à la valeur binaire complémentaire $\overline{A}$ de la valeur binaire A mémorisée sur le noeud de stockage BLTI de la cellule $10_{i,j}$. La valeur A est ainsi reportée sur la piste conductrice VGNDF par l'intermédiaire de la porte logique OU 33 et de l'inverseur 38. Le niveau final lu sur la piste de sortie RBLF de la colonne à la fin de l'opération de lecture correspond alors au résultat $\overline{A}.B$ d'une opération logique composée. De plus, la sortie inversée $\overline{RBLF}$ de la colonne, c'est-à-dire le noeud de sortie de l'inverseur 18, fournit un signal correspondant au résultat $A+\overline{B}$ de l'opération logique composée inverse.

Bien que l'on ait décrit ici un exemple de mise en oeuvre d'une opération logique composée à deux opérandes, des opérations logiques composées à plus de deux opérandes peuvent être mises en oeuvre de façon similaire, en activant simultanément en lecture un nombre supérieur à deux de cellules d'une même colonne. Chaque cellule activée est activée via un seul de ses ports de lecture RPT et RPF, au moins une cellule étant activée via son port RPT et au moins une cellule étant activée via son port RPF. De plus, des opérations logiques composées peuvent être mises en oeuvre sur des mots de plusieurs bits en activant simultanément plusieurs colonnes du circuit.

Les circuits mémoires des figures 2 et 3 permettent en outre de réaliser des opérations de type majorité, permettant de déterminer si une colonne de la matrice ou une portion d'une colonne de la matrice contient une majorité de 1 ou une majorité de 0. Pour cela, le circuit de contrôle 14 active simultanément, pour chaque cellule élémentaire de la colonne ou de la portion de colonne concernée par l'opération, les deux ports de lecture RPT et RPF de la cellule, après avoir préchargé à un niveau haut les pistes conductrices de sortie RBLT et RBLF de la colonne et, en maintenant à un niveau bas les pistes conductrices de référence VGNDT et VGNDF de la colonne. Après un temps de décharge fixe prédéterminé, le signe de la différence de tension $\Delta V = V_{RBLT} - V_{RBLF}$ entre les pistes conductrices RBLT et RBLF de la colonne est déterminé. Lorsque la colonne ou la portion de colonne activée contient une majorité de 1, la piste de sortie RBLT se décharge plus rapidement que la piste de sortie RBLF, et la tension $\Delta V$ est négative à la fin du temps de décharge fixé. Si en revanche la colonne ou la portion de colonne activée contient une majorité de 0, la piste de sortie RBLF se décharge plus rapidement que la piste de sortie RBLT, et la tension $\Delta V$ est positive à la fin du temps de décharge fixé. Le signe pris par la tension $\Delta V$ à la fin du temps de décharge prédéterminé permet ainsi de savoir si la colonne ou la portion de colonne activée contient une majorité de 1 ou une majorité de 0. Le signe de la tension $\Delta V$ peut être déterminé au moyen d'un amplificateur de sortie, non représenté, par exemple disposé en pied de colonne, adapté à amplifier la différence de tension $\Delta V = V_{RBLT} - V_{RBLF}$ et à fournir un signal binaire représentatif du signe de cette différence.

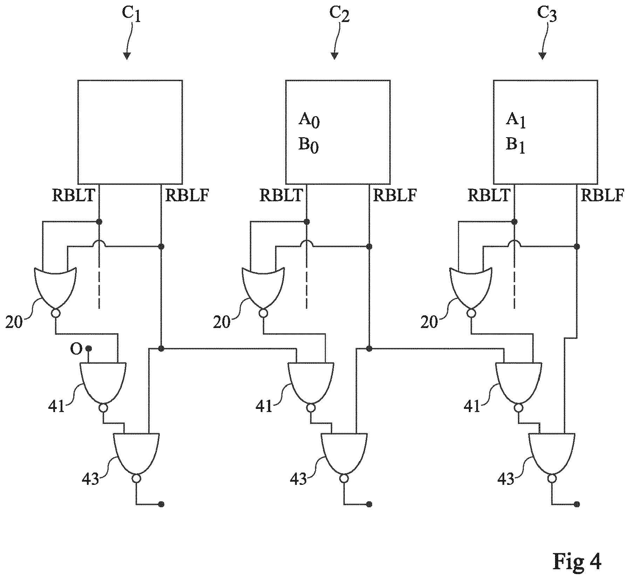

La figure 4 représente de façon schématique une autre variante de réalisation d'un circuit mémoire adapté à mettre en oeuvre des opérations de calcul.

Le circuit mémoire de la figure 4 comprend par exemple les mêmes éléments que le circuit mémoire de la figure 2 ou 3, agencés sensiblement de la même manière, et comprend en outre des éléments de circuit supplémentaires permettant de mettre en oeuvre des opérations de calcul arithmétique.

Plus particulièrement, le circuit de la figure 4 comprend, pour chaque colonne de la matrice, en plus des éléments décrits en relation avec les figures 2 et 3, deux portes NON ET 41 et 43 formant avec la porte NON OU 20 de la colonne, un demi-additionneur. Dans chaque colonne de rang j de la matrice, à l'exception de la première colonne (j=1), la porte 41 a une première entrée reliée à la piste conductrice de sortie RBLF de la colonne de rang précédent (j-1), et une deuxième entrée reliée à la sortie de la porte NON OU 20 de la colonne de rang j. La porte 41 de la colonne de rang j=1 a une première entrée reliée à un noeud d'application d'un signal de niveau bas (valeur binaire 0), et une deuxième entrée reliée à la sortie de la porte NON OU 20 de la colonne de rang j=1. Chaque porte NON ET 41 a en outre une deuxième entrée connectée à la sortie de la porte NON OU 20 de la colonne à laquelle elle appartient. Chaque porte NON ET 43 a une première entrée reliée à la piste conductrice de sortie RBLF de la colonne à laquelle elle appartient, et une deuxième entrée reliée à la sortie de la porte NON ET 41 de la colonne à laquelle elle appartient.

Dans l'exemple de la figure 4, seules les trois premières colonnes $C_1$, $C_2$, $C_3$ de la matrice ont été représentées. De plus, ces colonnes n'ont pas été détaillées. En particulier, en figure 4, les cellules élémentaires présentes dans chaque colonne ne sont pas détaillées. Seules les pistes conductrices de sortie RBLT et RBLF de chaque colonne, ainsi que les portes logiques 20, 41 et 43 associées à chaque colonne, sont détaillées. En outre, le circuit de contrôle 14 du circuit mémoire n'a pas été représenté sur la figure 4.

Le déroulement d'une opération d'addition à deux opérandes de deux bits $A_0A_1$ et $B_0B_1$ va maintenant être décrit en relation avec la figure 4. Les deux bits $A_0$ et $A_1$ du premier opérande sont stockés dans deux cellules d'une même première ligne de la mémoire, respectivement dans la colonne $C_2$ et dans la colonne $C_3$ dans l'exemple représenté, et les deux bits $B_0$ et $B_1$ du deuxième opérande sont stockés dans deux cellules d'une même deuxième ligne de la mémoire, dans les mêmes colonnes que les bits $A_0$ et $A_1$ respectivement, c'est-à-dire dans les colonnes $C_2$ et $C_3$ dans cet exemple. Le temps d'exécution de l'opération d'addition, correspond au temps nécessaire à la mise en oeuvre de trois cycles de lecture dans la mémoire.

Lors d'un premier cycle, le circuit de contrôle 14 est commandé de façon identique ou similaire à ce qui a été décrit en relation avec la figure 2, pour activer simultanément en lecture, via les deux ports de lecture RPT et RPF, les deux lignes du circuit mémoire contenant respectivement les bits $A_0$ et $A_1$ et les bits $B_0$ et $B_1$, après avoir préchargé à un niveau haut les pistes de sortie RBLT et RBLF des colonnes $C_2$ et $C_3$, et rendu passants les transistors 22 et 24 (non visibles sur la figure 4) des colonnes $C_2$ et $C_3$. A la fin du premier cycle, le signal $S_{i0}$ de sortie de la porte NON OU 20 de la colonne $C_2$ correspond au résultat d'une opération OU EXCLUSIF entre les bits $A_0$ et $B_0$, et le signal $S_{i1}$ de sortie de la porte NON OU 20 de la colonne $C_3$ correspond au résultat d'une opération OU EXCLUSIF entre les bits $A_1$ et $B_1$. Les signaux $S_{i0}$ et $S_{i1}$ correspondent aux résultats, dans chaque colonne, de la somme, sans retenue, des valeurs $A_0$ et $B_0$, respectivement $A_1$ et $B_1$. Le signal présent sur la piste de sortie RBLF de la colonne $C_1$ correspond à la retenue d'entrée $C_{in0}$ du demi-additionneur de la colonne $C_2$, et le signal présent sur la piste de sortie RBLF de la colonne $C_3$ correspond à la retenue d'entrée $C_{in1}$ du demi-additionneur de la colonne $C_3$. Le signal de sortie de la porte NON ET 43 de la colonne $C_1$ correspond à la retenue de sortie $C_{out0}$ du demi-additionneur de la colonne $C_1$, le signal de sortie de la porte NON ET 43 de la colonne $C_2$ correspond à la retenue de sortie $C_{out1}$ du demi-additionneur de la colonne $C_2$, et le signal de sortie de la porte NON ET 43 de la colonne $C_3$ correspond à

la retenue de sortie $C_{out2}$ du demi-additionneur de la colonne $C_3$. A la fin du premier cycle, les valeurs $S_{i0}$ et $S_{i1}$ sont écrites respectivement dans les colonnes $C_2$ et $C_3$, dans une même ligne du circuit mémoire distincte des lignes contenant les valeurs $A_0$, $A_1$ et $B_0$, $B_1$.

Lors d'un deuxième cycle consécutif au premier cycle, les pistes conductrices de sortie RBLT et RBLF ne sont pas rechargées à un niveau haut, de sorte que les valeurs des retenues $C_{in0}$, $C_{in1}$, $C_{out0}$, $C_{out1}$, $C_{out2}$ restent conservées. Lors du deuxième cycle, les retenues de sortie $C_{out0}$ et $C_{out1}$, disponibles respectivement sur le noeud de sortie de la porte 43 de la colonne $C_1$ et sur le noeud de sortie de la porte 43 de la colonne $C_2$, sont écrites respectivement dans la colonne $C_2$ et dans la colonne $C_3$, dans une même ligne du circuit mémoire distincte des lignes contenant les valeurs $A_0$, $A_1$, $B_0$, $B_1$ et $S_{i0}$, $S_{i1}$.

Lors d'un troisième cycle consécutif au deuxième cycle, le circuit de contrôle 14 est à nouveau commandé de façon identique ou similaire à ce qui a été décrit en relation avec la figure 2, pour activer simultanément en lecture, via les deux ports de lecture RPT et RPF, les deux lignes du circuit mémoire contenant respectivement les bits $S_{i0}$ et $S_{i1}$ et les bits $C_{out0}$ et $C_{out1}$, après avoir préchargé à un niveau haut les pistes de sortie RBLT et RBLF des colonnes $C_2$ et $C_3$, et rendu passants les transistors 22 et 24 (non visibles sur la figure 4) des colonnes $C_2$ et $C_3$. A la fin du troisième cycle, le signal S0 de sortie de la porte NON OU 20 de la colonne $C_2$ correspond au résultat d'une opération OU EXCLUSIF entre les bits $S_{i0}$ et $C_{out0}$, et le signal S1 de sortie de la porte NON OU 20 de la colonne $C_3$ correspond au résultat d'une opération OU EXCLUSIF entre les bits $S_{i1}$ et $C_{out1}$. Les signaux S0 et S1 correspondent respectivement au bit de poids fort et au bit de poids faible du résultat final de l'addition. Le signal disponible sur le noeud de sortie de la porte NON ET 43 de la colonne $C_3$ correspond quant à lui à la valeur finale $C_{out}$ de la retenue de l'addition.

Des soustractions peuvent être réalisées de façon similaire mais avec un cycle supplémentaire, car la valeur des retenues ne correspond alors plus à un ET comme dans le cas de l'addition, mais à une opération logique composée de type $A.\overline{B}$.

Des opérations d'incrément ou de décrément peuvent en outre être mises en oeuvre en utilisant les circuits d'addition/soustraction décrits ci-dessus.

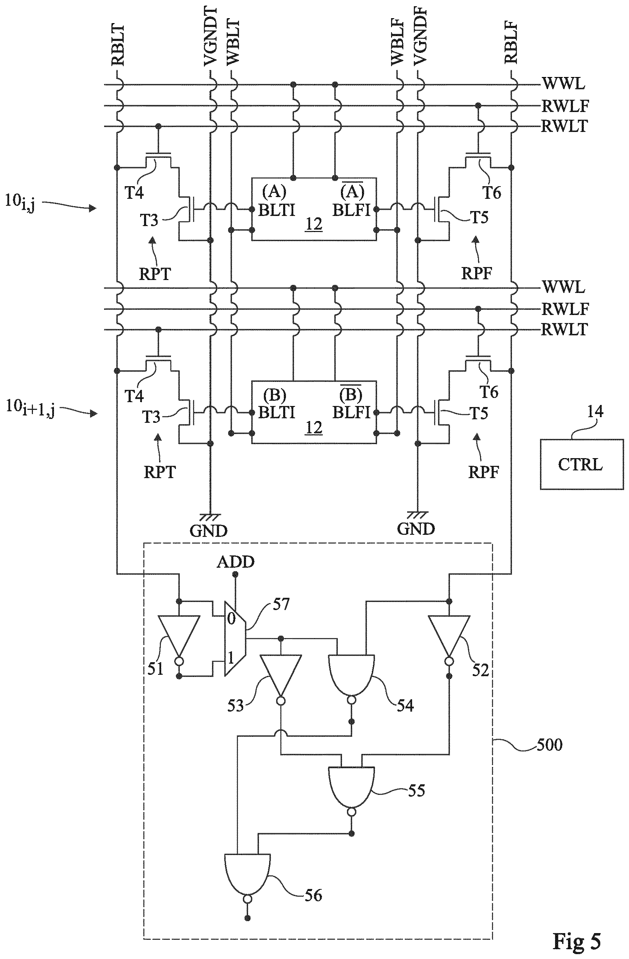

La figure 5 représente de façon schématique un exemple particulièrement avantageux d'un circuit mémoire selon un mode de réalisation.

Le circuit mémoire de la figure 5 diffère du circuit mémoire de la figure 2 principalement en ce que, dans le circuit de la figure 5, dans chaque colonne de la matrice, les inverseurs 16 et 18 et la porte NON OU 20 sont remplacés par un circuit logique 500.

Le circuit logique 500 comprend trois inverseurs 51, 52 et 53, trois portes logiques NON ET 54, 55 et 56, et un multiplexeur 57 à deux entrées binaires et une sortie binaire de données. L'inverseur 51 a son entrée reliée à la piste conductrice de sortie RBLT de la colonne et l'inverseur 52 a son entrée reliée à la piste conductrice de sortie RBLF de la colonne. Le multiplexeur 57 a une première entrée de données (0) reliée à l'entrée de l'inverseur 51, et une deuxième entrée de données (1) reliée à la sortie de l'inverseur 51. La sortie du multiplexeur 57 est reliée à l'entrée de l'inverseur 53 et à une première entrée de la porte NON ET 54. Le multiplexeur 57 comprend en outre une entrée de commande ADD permettant de sélectionner l'entrée de données (0) ou (1) du multiplexeur à reproduire sur sa sortie. La deuxième entrée de la porte NON ET 54 est reliée à l'entrée de l'inverseur 52. La sortie de l'inverseur 52 est reliée à une première entrée de la porte NON ET 55 et la sortie de l'inverseur 53 est reliée à la deuxième entrée de la porte NON ET 55. La sortie de la porte NON ET 54 est reliée à une première entrée de la porte NON ET 56, et la sortie de la porte NON ET 55 est reliée à la deuxième entrée de la porte NON ET 56.

Dans l'exemple représenté, les pistes conductrices de référence VGNDT et VGNDF de la colonne sont directement reliées à la masse (GND). A titre de variante, les pistes conductrices de référence VGNDT et VGNDF peuvent être reliées à la masse par l'intermédiaire de transistors 22 et 24 tel que décrit en relation avec la figure 2.

Le circuit de contrôle 14 (CTRL) est adapté à commander le circuit mémoire pour mettre en oeuvre des opérations de lecture classiques du type décrit en relation avec la figure 1, ou pour mettre en oeuvre des opérations d'écriture via les pistes conductrices d'accès en écriture WBLT, WBLF, et WWL des cellules.

Le circuit de contrôle 14 est en outre adapté à commander le circuit mémoire pour mettre en oeuvre un certain nombre d'opérations logiques de base directement dans la mémoire, sans avoir à faire transiter les données par une unité externe au circuit.

Pour cela, le circuit de contrôle 14 est adapté à activer simultanément en lecture deux, ou un nombre supérieur à deux, de cellules élémentaires d'une même colonne du circuit, via les ports d'accès RPT, et/ou via les ports d'accès RPF de ces cellules.

A titre d'exemple illustratif, on considère que les deux cellules $10_{i,j}$ et $10_{i+1,j}$ représentées en figure 5 sont activées simultanément en lecture, l'une (la cellule $10_{i,j}$) via son seul port RPT, et l'autre (la cellule $10_{i,j+1}$) via son seul port RPF. Pour cela, après avoir préchargé à un niveau haut les pistes conductrices de sortie RBLT et RBLF de la colonne et mis à un niveau bas les pistes conductrices de référence VGNDT et VGNDF de la colonne, le transistor de sélection T4 de la cellule $10_{i,j}$ et le transistor de sélection T6 de la cellule $10_{i,j+1}$ sont simultanément rendus passants par le circuit de contrôle 14, les transistors de sélection T6 de la cellule $10_{i,j}$ et T4 de la cellule $10_{i,j+1}$ étant maintenus bloqués. On désigne par A la valeur binaire mémorisée sur le noeud BLTI de la cellule $10_{i,j}$ et par B la valeur binaire mémorisée sur le noeud BLTI de la cellule La cellule $10_{i,j}$ stocke alors sur son noeud BLFI le complémentaire $\overline{A}$ de la valeur A, et la cellule $10_{i+1,j}$ stocke sur son noeud BLFI le complémentaire $\overline{B}$ de la valeur B. Suite à l'activation de la cellule $10_{i,j}$ via son port RPT et de la cellule $10_{i,j+1}$ via son port RPF, la valeur $\overline{A}$ peut être lue sur la piste de sortie RBLT de la colonne et la valeur B peut être lue sur la piste de sortie RBLF de la colonne. Les valeurs A et $\overline{B}$ peuvent être lues respectivement sur les noeuds de sortie des inverseurs 51 et 52. Selon un premier mode de fonctionnement, le multiplexeur 57 est commandé par le circuit de contrôle 14, via son entrée de commande ADD, pour relier sa première entrée de données (0) à sa sortie. La valeur $\overline{A}.B$ peut alors être lue sur le noeud de sortie de la porte NON ET 54, et la valeur $\overline{A.\overline{B}}$ peut être lue sur le noeud de sortie de la porte NON ET 55. La valeur sur le noeud de sortie de la porte NON ET 56 correspond au résultat XOR(A,B) d'une opération OU EXCLUSIF entre les valeurs A et B. Selon un deuxième mode de fonctionnement, le multiplexeur 57 est commandé par le circuit de contrôle 14 pour relier sa deuxième entrée de données (1) à sa sortie. La valeur $\overline{A}.B$ peut alors être lue sur le noeud de sortie de la porte NON ET 54, et la valeur $\overline{\overline{A}.\overline{B}}$ (c'est-à-dire A OU B) peut être lue sur le noeud de sortie de la porte NON ET 55. La valeur sur le noeud de sortie de la porte NON ET 56 correspond au résultat NXOR(A,B) d'une opération OU EXCLUSIF complémentée entre les valeurs A et B.

A titre de variante, on considère que les deux cellules $10_{i,j}$ et $10_{i+1,j}$ représentées en figure 5 sont activées simultanément en lecture via leurs deux ports de lecture RPT et RPF. Pour cela, après avoir préchargé à un niveau haut les pistes conductrices de sortie RBLT et RBLF de la colonne et mis à un niveau bas les pistes conductrices de référence VGNDT et VGNDF de la colonne, les transistors de sélection T4 et T6 de la cellule $10_{i,j}$ et les transistors de sélection T4 et T6 de la cellule $10_{i,j+1}$ sont simultanément rendus passants par le circuit de contrôle 14. Suite à l'activation de la cellule $10_{i,j}$ via ses ports RPT et RPF et de la cellule $10_{i,j+1}$ via ses ports RPT et RPF, la valeur $\overline{A+B}$ (opération logique NON OU) peut être lue sur la piste de sortie RBLT de la colonne et la valeur A.B (opération logique ET) peut être lue sur la piste de sortie RBLF de la colonne. Les valeurs A+B (opération logique OU) et $\overline{A.B}$ (opération logique NON ET) peuvent être lues respectivement sur les noeuds de sortie des inverseurs 51 et 52. Selon un troisième mode de fonctionnement, le multiplexeur 57 est commandé par le circuit de contrôle 14 pour relier sa première entrée de données (0) à sa sortie. La valeur NXOR(A,B) peut alors être lue sur le noeud de sortie de la porte NON ET 55, et la valeur XOR(A,B) peut être lue sur le noeud de sortie de la porte NON ET 56. Selon un quatrième mode de fonctionnement, le multiplexeur 57 est commandé par le circuit de contrôle 14 pour relier sa deuxième entrée de données (1) à sa sortie. La valeur $\overline{A}.B$ peut alors être lue sur le noeud de sortie de la porte logique NON ET 54, la valeur A+B peut être lue sur le noeud de sortie de la porte logique NON ET 55, et la valeur NXOR(A,B) peut être lue sur le noeud de sortie de la porte NON ET 56.

En activant simultanément en lecture un nombre supérieur à deux de cellules d'une même colonne, les opérations logiques susmentionnées peuvent être mises en oeuvre avec un nombre d'opérandes supérieur à 2. De plus, en activant simultanément en lectures plusieurs colonnes du circuit, ces opérations logiques peuvent être mises en oeuvre sur des mots de plusieurs bits.

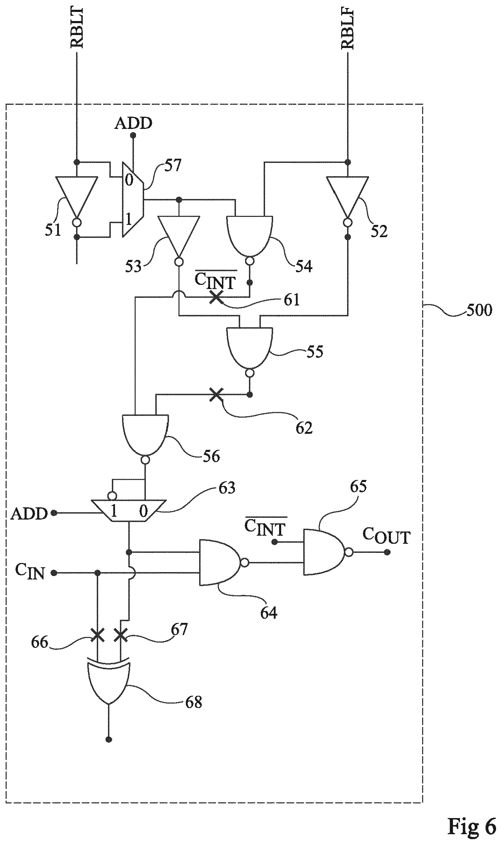

La figure 6 représente de façon schématique une variante de réalisation particulièrement avantageuse du circuit mémoire de la figure 5.

Le circuit mémoire de la figure 6 comprend les mêmes éléments que le circuit mémoire de la figure 5, agencés sensiblement de la même manière, et diffère du circuit mémoire de la figure 5 en ce que, dans le circuit mémoire de la figure 6, dans chaque colonne de la matrice, le circuit logique 500 comprend des éléments supplémentaires adaptés à la mise en oeuvre d'opérations arithmétiques. Plus particulièrement, dans l'exemple de la figure 6, dans chaque colonne de la matrice, le circuit logique 500 comprend en outre une bascule (latch) 61, par exemple une bascule D, dont l'entrée est reliée au noeud de sortie de la porte NON ET 54 et dont la sortie est reliée à la première entrée de la porte NON ET 56 et de la porte NON ET 65, et une bascule 62, par exemple une bascule D, dont l'entrée est reliée au noeud de sortie de la porte NON ET 55 et dont la sortie est reliée à la deuxième entrée de la porte NON ET 56. Le circuit 500 comprend de plus un multiplexeur 63 à deux entrées binaires et une sortie binaire. Le multiplexeur 63 a une première entrée de données (0) reliée à la sortie de la porte logique NON ET 56, et une deuxième entrée de données (1) reliée à une sortie inversée de la porte logique NON ET 56. Le circuit 500 comprend par ailleurs une porte logique NON ET 64 dont une première entrée est reliée à la sortie du multiplexeur 63 et dont la deuxième entrée est reliée à un noeud $C_{IN}$. Le multiplexeur 63 comprend en outre une entrée de commande ADD permettant de sélectionner l'entrée de données (0) ou (1) du multiplexeur à reproduire sur sa sortie. Le circuit 500 comprend en outre une porte logique NON ET 65 dont une première entrée est reliée à la sortie de la porte NON ET 64, et dont la deuxième entrée est reliée à un noeud $\overline{C_{INT}}$ relié à la sortie de la bascule 61. La sortie de la porte logique NON ET 65 est reliée à un noeud $C_{OUT}$ du circuit 500. Le circuit 500 comprend en outre une bascule 66, par exemple une bascule D, dont l'entrée est reliée au noeud $C_{IN}$, et une bascule 67, par exemple une bascule D, dont l'entrée est reliée au noeud de sortie du multiplexeur 63. Le circuit 500 comprend de plus une porte logique OU EXCLUSIF 68 dont une première entrée est reliée à la sortie de la bascule 66 et dont la deuxième entrée est reliée à la sortie de la bascule 67. La sortie de la porte OU EXCLUSIF 68 est reliée à un noeud S du circuit 500.

Dans le circuit mémoire de la figure 6, les circuits 500 de plusieurs colonnes de la matrice, par exemple des colonnes voisines de la matrice, sont reliés en chaîne par l'intermédiaire de leurs noeuds $C_{IN}$ et $C_{OUT}$ pour former un circuit d'addition/soustraction. On considère à titre d'exemple que les circuits 500 de Q colonnes distinctes de la matrice sont reliés en chaîne pour former un circuit d'addition/soustraction d'opérandes à Q-bits. On désigne ci-après par $500_k$ le circuit de la k-ième colonne de l'ensemble de Q colonnes formant le circuit d'addition-soustraction, avec k entier allant de 1 à Q et Q entier inférieur ou égal à N (N désignant le nombre de colonnes de la matrice). Dans cet exemple, les colonnes de rang k faible du circuit d'addition/soustraction correspondent aux bits de poids faible du circuit d'addition/soustraction, et les colonnes de rang k élevé du circuit d'addition/soustraction correspondent aux bits de poids fort du circuit d'addition/soustraction. A l'exception du circuit $500_1$, chaque circuit $500_k$ du circuit d'addition / soustraction a son noeud $C_{IN}$ relié au noeud $C_{OUT}$ du circuit de rang précédent $500_{k-1}$. Le circuit d'addition/soustraction comprend en outre une bascule de sortie supplémentaire non représentée, dont l'entrée est reliée au noeud $C_{OUT}$ du circuit $500_Q$.

Le déroulement d'une opération d'addition à deux opérandes de Q-bits chacune va maintenant être décrit. Les Q bits $A_1$, $A_2$, ..., $A_k$, ...$A_Q$ (du bit de poids le plus faible au bit de poids le plus fort) du premier opérande sont stockés dans une même première ligne de rang il de la mémoire, respectivement dans les Q colonnes de rang 1 à Q définissant le circuit d'addition / soustraction. Les Q bits $B_1$, $B_2$, ..., $B_k$, ...$B_Q$ (du bit de poids le plus faible au bit de poids le plus fort) du deuxième opérande sont stockés dans une même deuxième ligne de rang i2 de la mémoire, respectivement dans les Q colonnes de rang 1 à Q de la mémoire définissant le circuit d'addition/soustraction. Dans l'exemple qui va être décrit, le temps d'exécution de l'opération d'addition correspond au temps nécessaire à la mise en oeuvre de trois cycles de lecture dans la mémoire. Les modes de réalisation décrits ne se limitent toutefois pas à ce cas particulier.

Pendant l'opération d'addition, le circuit de contrôle 14 applique un potentiel de niveau bas correspondant à la valeur binaire '0', par exemple le potentiel GND, sur le noeud $C_{IN}$ du circuit $500_1$ du circuit d'addition/soustraction. De plus, le circuit de contrôle 14 commande le multiplexeur 57 pour relier sa deuxième entrée de données (1) à sa sortie, et le multiplexeur 63 pour relier sa deuxième entrée de données (1) à sa sortie.

Lors d'un premier cycle, le circuit de contrôle 14 est commandé pour activer simultanément en lecture les deux lignes de rang i1 et i2 de la mémoire, l'une (la ligne de rang il) via ses seuls ports de lecture RPT, et l'autre (la ligne de rang i2) via ses seuls ports de lecture RPF. A la fin du premier cycle, dans chaque colonne de rang k du circuit d'addition/soustraction, la bascule 61 du circuit $500_k$ mémorise la valeur $\overline{A_k.B_k}$ correspondant au complémentaire de la retenue locale de rang k de l'addition, c'est-à-dire de la retenue de l'addition bit à bit des valeurs $A_k$ et $B_k$. De plus, à la fin du premier cycle, la bascule 62 du circuit $500_k$ mémorise la valeur $\overline{\overline{A_k}.\overline{B_k}}$.

Lors d'un deuxième cycle consécutif au premier cycle, les valeurs mémorisées dans les bascules 61 et 62 sont transmises sur les noeuds de sortie de ces bascules. Dans chaque colonne de rang k du circuit d'addition/soustraction, la valeur sur le noeud de sortie du multiplexeur 63 est alors égale à XOR($A_k$,$B_k$), c'est-à-dire dire au résultat de l'addition bit à bit des valeurs $A_k$ et $B_k$. A la fin du deuxième cycle, cette valeur est mémorisée dans la bascule 67. De plus, lors du deuxième cycle, les retenues locales de l'addition sont propagées par les portes NON ET 64 et 65, et, dans chaque colonne de rang k du circuit d'addition/soustraction, la bascule 66 du circuit $500_k$ mémorise la valeur de retenue locale propagée appliquée sur son noeud $C_{IN}$. A la fin du deuxième cycle, la valeur du noeud $C_{OUT}$ du circuit $500_Q$, correspondant à la valeur finale de retenue de l'addition, est mémorisée dans la bascule supplémentaire (non représentée) associée au circuit $500_Q$.

Lors d'un troisième cycle consécutif au deuxième cycle, les valeurs mémorisées dans les bascules 66 et 67 sont transmises sur les noeuds de sortie de ces bascules. Le résultat de l'addition correspond alors au mot de Q bits formé par les Q valeurs binaires fournies sur les noeuds de sortie S des circuits $500_k$ du circuit d'addition/soustraction, auquel s'ajoute le bit de retenue mémorisé dans la bascule supplémentaire (non représentée) associée au circuit $500_Q$.

Le déroulement d'une opération de soustraction de deux opérandes de Q-bits est similaire au déroulement d'une opération d'addition, à ceci près que, pendant une opération de soustraction, le circuit de contrôle 14 applique un potentiel de niveau haut correspondant à la valeur binaire '1', par exemple le potentiel VDD, sur le noeud $C_{IN}$ du circuit $500_1$ du circuit d'addition/soustraction. De plus, pendant l'opération de soustraction, le circuit de contrôle 14 commande le multiplexeur 57 pour relier sa première entrée de données (0) à sa sortie, et le multiplexeur 63 pour relier sa première entrée de données (0) à sa sortie.

On notera que dans l'exemple de la figure 6, les multiplexeurs 57 et 63 peuvent être commandés par un même signal de commande fourni par le circuit de contrôle 14.

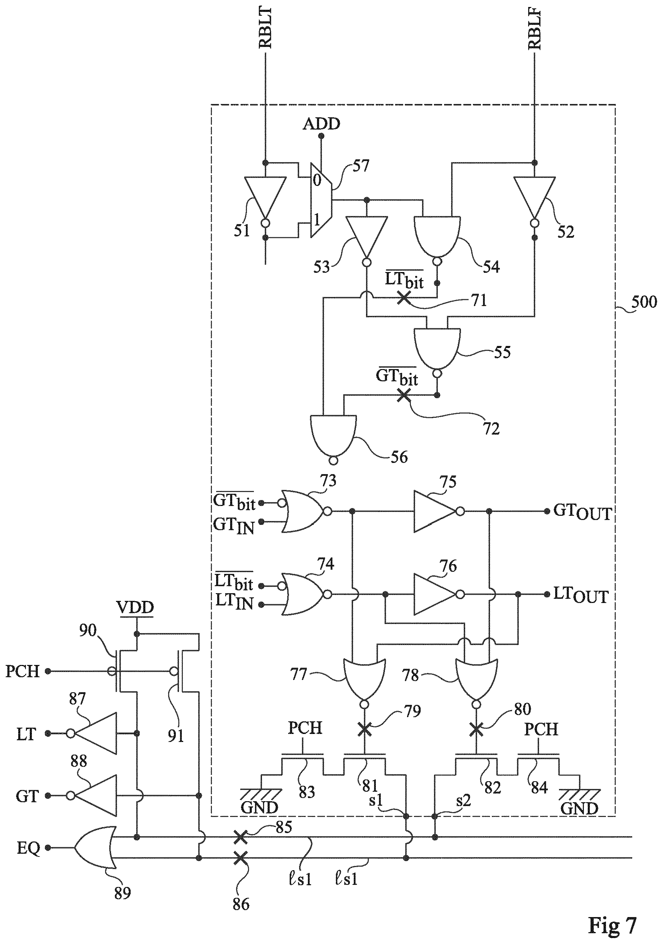

La figure 7 représente de façon schématique une autre variante de réalisation du circuit mémoire de la figure 5.

Le circuit mémoire de la figure 7 comprend les mêmes éléments que le circuit mémoire de la figure 5, agencés sensiblement de la même manière, et diffère du circuit mémoire de la figure 5 en ce que, dans le circuit mémoire de la figure 7, dans chaque colonne de la matrice, le circuit logique 500 comprend des éléments supplémentaires adaptés à la mise en oeuvre d'opérations de comparaison. Plus particulièrement, dans l'exemple de la figure 7, dans chaque colonne de la matrice, le circuit logique 500 comprend en outre une bascule 71, par exemple une bascule D, dont l'entrée est reliée au noeud de sortie de la porte NON ET 54 et dont la sortie est reliée à la première entrée de la porte NON ET 56, et une bascule 72, par exemple une bascule D, dont l'entrée est reliée au noeud de sortie de la porte NON ET 55 et dont la sortie est reliée à la deuxième entrée de la porte NON ET 56. Le circuit 500 comprend de plus une porte logique NON OU 73 dont une première entrée est reliée, par l'intermédiaire d'un inverseur, à un noeud $\overline{GT_{bit}}$ relié à la sortie de la bascule 72, et dont la deuxième entrée est reliée à un noeud GT$_{IN}$. Le circuit 500 comprend de plus une porte logique NON OU 74 dont une première entrée est reliée, par l'intermédiaire d'un inverseur, à un noeud $\overline{LT_{bit}}$ relié à la sortie de la bascule 71, et dont la deuxième entrée est reliée à un noeud LT$_{IN}$. Le circuit 500 comprend en outre un inverseur 75 dont l'entrée est reliée à la sortie de la porte NON OU 73 et dont la sortie est reliée à un noeud GT$_{OUT}$, et un inverseur 76 dont l'entrée est reliée à la sortie de la porte NON OU 74 et dont la sortie est reliée à un noeud LT$_{OUT}$. Le circuit 500 comprend de plus une porte NON OU 77 dont une première entrée est reliée à la sortie de la porte NON OU 73 et dont la deuxième entrée est reliée au noeud LT$_{OUT}$, et une porte NON OU 78 dont une première entrée est reliée à la sortie de la porte NON OU 74 et dont la deuxième entrée est reliée au noeud GT$_{OUT}$. Le circuit 500 comprend en outre une bascule 79, par exemple une bascule D, dont l'entrée est reliée à la sortie de la porte NON OU 77, et une bascule 80, par exemple une bascule D, dont l'entrée est reliée à la sortie de la porte NON OU 78. Dans cet exemple, le circuit 500 comprend de plus un transistor 81 dont la grille est reliée à la sortie de la bascule 79, et un transistor 82 dont la grille est reliée à la sortie de la bascule 80. Le transistor 81 a un premier noeud de conduction relié à un noeud de sortie s1 du circuit 500 et un deuxième noeud de conduction relié à la masse (GND), et le transistor 82 a un premier noeud de conduction relié à un noeud de sortie s2 du circuit 500 et un deuxième noeud de conduction relié à la masse (GND). Dans l'exemple représenté, le deuxième noeud de conduction du transistor 81 est relié à la masse par l'intermédiaire d'un transistor 83, et le deuxième noeud de conduction du transistor 82 est relié à la masse par l'intermédiaire d'un transistor 84. Dans l'exemple représenté, les transistors 81, 82, 83, 84 sont des transistors MOS à canal N. De plus, dans cet exemple, les transistors 83 et 84 ont leurs grilles reliées à un même noeud d'application d'un signal de commande PCH.

Dans le circuit mémoire de la figure 7, les circuits 500 de plusieurs colonnes de la matrice, par exemple des colonnes voisines de la matrice, sont reliés en chaîne par l'intermédiaire de leurs noeuds GT$_{IN}$, GT$_{OUT}$ et LT$_{IN}$, LT$_{OUT}$ pour former un circuit de comparaison. On considère à titre d'exemple que les circuits 500 de R colonnes distinctes de la matrice sont reliés en chaîne pour former un circuit de comparaison d'opérandes à R-bits. On désigne ci-après par 500$_I$ le circuit de la 1-ième colonne de l'ensemble de R colonnes formant le circuit de comparaison, avec I entier allant de 1 à R et R entier inférieur ou égal à N (N désignant le nombre de colonnes de la matrice). Dans cet exemple, les colonnes de rang I faible du circuit de comparaison correspondent aux bits de poids fort du circuit de comparaison, et les colonnes de rang I élevé du circuit de comparaison correspondent aux bits de poids faible du circuit de comparaison. A l'exception du circuit 500$_1$, chaque circuit 500$_I$ du circuit de comparaison a son noeud GT$_{IN}$ relié au noeud GT$_{OUT}$ du circuit de rang précédent 500$_{I-1}$, et a son noeud LT$_{IN}$ relié au noeud LT$_{OUT}$ du circuit de rang précédent 500$_{I-1}$. Les noeuds de sortie s1 des R circuits 500$_I$ du circuit de comparaison sont reliés à une même première piste conductrice de sortie ls1 du circuit de comparaison, et les noeuds de sortie s2 des R circuits 500$_I$ du circuit de comparaison sont reliés à une même deuxième piste conductrice de sortie ls2 du circuit de comparaison. Le circuit de comparaison comprend en outre une bascule 85, par exemple une bascule D, dont l'entrée est reliée à la piste conductrice ls1, et une bascule 86, par exemple une bascule D, dont l'entrée est reliée à la piste conductrice ls2. Le circuit de comparaison comprend de plus un inverseur 87 dont l'entrée est reliée à la sortie de la bascule 85, et un inverseur 88 dont l'entrée est reliée à la sortie de la bascule 86. Dans cet exemple, le circuit de comparaison comprend en outre une porte OU 89 dont une première entrée est reliée à la sortie de la bascule 85 et dont la deuxième entrée est reliée à la sortie de la bascule 86. La sortie de l'inverseur 87 est reliée à un noeud LT, la sortie de l'inverseur 88 est reliée à un noeud GT, et la sortie de la porte OU 89 est reliée à un noeud EQ. Le circuit de comparaison comprend par ailleurs un transistor 90 reliant, via ses noeuds de conduction, la piste conductrice ls1 à un noeud d'application d'un potentiel de référence haut, par exemple le potentiel d'alimentation haut VDD, et un transistor 91 reliant, via ses noeuds de conduction, la piste conductrice ls2 au noeud VDD. Les transistors 90 et 91 ont leurs grilles reliées à un même noeud d'application d'un signal de commande. Dans cet exemple, les transistors 90 et 91 sont des transistors MOS à canal P et ont leurs grilles reliées au même noeud de commande PCH que les transistors 83 et 84.

Le déroulement d'une opération de comparaison à deux opérandes de R-bits chacune va maintenant être décrit. Les R bits A$_1$, A$_2$, ..., A$_I$, ...A$_R$ (du bit de poids le plus fort au bit de poids le plus faible) du premier opérande sont stockés dans une même première ligne de rang il de la mémoire, respectivement dans les R colonnes de rang 1 à R définissant le circuit de comparaison. Les R bits $B_1$, $B_2$, ..., $B_l$, ...$B_R$ (du bit de poids le plus fort au bit de poids le plus faible) du deuxième opérande sont stockés dans une même deuxième ligne de rang i2 de la mémoire, respectivement dans les R colonnes de rang 1 à R de la mémoire définissant le circuit de comparaison. Dans l'exemple qui va être décrit, le temps d'exécution de l'opération de comparaison correspond au temps nécessaire à la mise en oeuvre de trois cycles de lecture dans la mémoire. Les modes de réalisation décrits ne se limitent toutefois pas à ce cas particulier. En particulier, à titre de variante, les deuxième et troisième cycles peuvent être confondus.

Pendant l'opération de comparaison, le circuit de contrôle 14 applique un potentiel de niveau bas correspondant à la valeur binaire '0', par exemple le potentiel GND, sur les noeuds $GT_{IN}$ et $LT_{IN}$ du circuit $500_1$ du circuit de comparaison. De plus, le circuit de contrôle 14 commande le multiplexeur 57 pour relier sa première entrée de données (0) à sa sortie.

Lors d'un premier cycle, le circuit de contrôle 14 est commandé pour activer simultanément en lecture les deux lignes de rang i1 et i2 de la mémoire, l'une (la ligne de rang il) via ses seuls ports de lecture RPT, et l'autre (la ligne de rang i2) via ses seuls ports de lecture RPF. A la fin du premier cycle, dans chaque colonne de rang l du circuit de comparaison, la bascule 71 du circuit $500_l$ mémorise la valeur $\overline{\overline{A_l}.B_l}$ correspondant au résultat complémenté de l'opération locale de comparaison $A_l < B_l$. De plus, la bascule 72 mémorise la valeur $\overline{A_l.\overline{B_l}}$ correspondant au résultat complémenté de l'opération locale de comparaison $A_l > B_l$.

Lors d'un deuxième cycle consécutif au premier cycle, les valeurs mémorisées dans les bascules 71 et 72 sont transmises sur les noeuds de sortie de ces bascules. A la fin du deuxième cycle, les valeurs de sortie des portes NON OU 77 et 78 sont mémorisées dans les bascules 79 et 80 respectivement.

Préalablement à un troisième cycle consécutif au deuxième cycle, les transistors 90 et 91 sont rendus passants puis bloqués, de façon à précharger les pistes conductrices ls1 et ls2 à un niveau haut. De plus, les transistors 83 et 84 sont rendus passants puis bloqués, de façon à précharger à un niveau bas le noeud de conduction commun entre les transistors 81 et 83, et le noeud de conduction commun entre les transistors 82 et 84.

Lors du troisième cycle, les valeurs mémorisées dans les bascules 79 et 80 sont transmises sur les noeuds de sortie de ces bascules. A la fin du troisième cycle, l'état des pistes conductrices de sortie ls1 et ls2 est représentatif du résultat final de la comparaison. Dans cet exemple, lors du troisième cycle, le niveau de la piste conductrice ls1 est mémorisé dans la bascule 85, et le niveau de la piste conductrice ls2 est mémorisé dans la bascule 86.

L'état du noeud de sortie LT du circuit de comparaison correspond alors au résultat de l'opération de comparaison $A_1A_2...A_l...A_R < B_1B_2...B_l...B_R$. L'état du noeud de sortie GT du circuit de comparaison correspond au résultat de l'opération de comparaison $A_1A_2...A_l...A_R > B_1B_2...B_l...B_R$. L'état du noeud de sortie EQ du circuit de comparaison correspond au résultat de l'opération de comparaison $A_1A_2...A_l...A_R = B_1B_2...B_l...B_R$.

On notera que les variantes de réalisation des figures 6 et 7 peuvent être combinées. Dans ce cas, les bascules 71 de la figure 7 et 61 de la figure 6 peuvent être confondues, et les bascules 72 de la figure 7 et 62 de la figure 6 peuvent être confondues.

On notera par ailleurs que les opérations d'addition/soustraction décrites en relation avec la figure 6, et/ou les opérations de comparaison décrites en relation avec la figure 7, peuvent être traitées en pipeline, de façon à pouvoir générer un résultat d'opération par cycle.

A titre de variante, les circuits mémoire décrits en relation avec les figures 2, 3 et 4, 5, 6 et 7 peuvent en outre comprendre des éléments de circuit (non représentés) permettant de mettre en oeuvre des opérations de décalage. Pour cela, le circuit mémoire peut comprendre, pour chaque colonne $C_j$, un multiplexeur commandable pour relier la piste conductrice de sortie RBLT de la colonne $C_j$ soit au circuit d'écriture (piste conductrice WBLT) de la même colonne $C_j$, de façon à mettre en oeuvre une opération de lecture-réécriture classique, soit au circuit d'écriture de la colonne $C_{j+1}$ de rang suivant, de façon à mettre en oeuvre une opération de décalage.

Des modes de réalisation particuliers ont été décrits. Diverses variantes et modifications apparaîtront à l'homme de l'art. En particulier, les modes de réalisation ne se limitent pas à l'exemple particulier de cellule élémentaire décrit en relation avec la figure 1. Plus généralement, les modes de réalisation décrits peuvent être adaptés à d'autres types de cellules mémoires élémentaires, volatiles ou non volatiles, à un ou plusieurs ports de lecture.

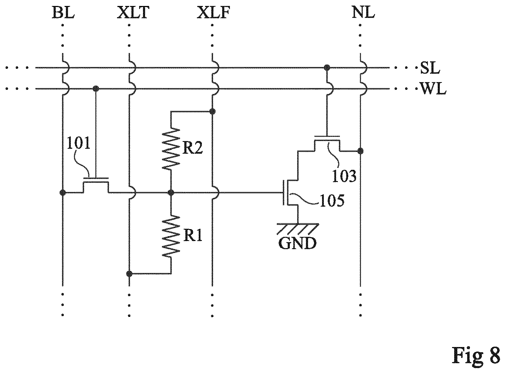

La figure 8 est un schéma électrique d'un exemple d'une cellule mémoire élémentaire non volatile à un seul port de lecture, pouvant être utilisée comme cellule de base d'un circuit mémoire adapté à mettre en oeuvre des opérations de calcul.

La cellule élémentaire de la figure 8 est une cellule mémoire résistive. Cette cellule comprend une cellule de stockage à deux éléments résistifs à résistance programmable R1 et R2, et un transistor 101. Les éléments R1 et R2 sont connectés en série entre un noeud XLT et un noeud XLF de la cellule. Le point milieu entre les éléments R1 et R2 définit un noeud de stockage de donnée de la cellule. Le transistor 101 est un transistor d'accès en écriture, reliant, via ses noeuds de conduction, le point milieu entre les éléments R1 et R2 à un noeud d'écriture BL de la cellule. La grille du transistor 101 est connectée à un noeud de commande WL de la cellule. La cellule élémentaire de la figure 8 comprend en outre un port de lecture RPT à deux transistors 103 et 105. Les transistors 103 et 105 sont montés en série via leurs noeuds de conduction entre une piste conductrice de sortie NL de la cellule et un noeud GND d'application d'un potentiel de référence de la cellule. Le transistor 105 est situé côté noeud GND et a sa grille reliée au point milieu entre les éléments résistifs R1 et R2. Le transistor 103 est situé côté piste conductrice NL et a sa grille reliée à une piste conductrice de contrôle de lecture SL. Dans cet exemple, les transistors 101, 103 et 105 sont des transistors MOS à canal N.

Un circuit mémoire selon un mode de réalisation peut comprendre une pluralité de cellules élémentaires du type décrit en relation avec la figure 8, identiques ou similaires, agencées en matrice selon des lignes et des colonnes. Les cellules d'une même ligne sont interconnectées via leurs pistes conductrices SL, respectivement WF, et les cellules d'une même colonne sont interconnectées via leurs pistes conductrices BL, respectivement XLT, respectivement XLF, respectivement NL.

Pour réaliser une lecture d'une cellule élémentaire de la mémoire via son port de lecture RPT, la piste conductrice de sortie NL de la cellule est préchargée à un niveau haut, par exemple à la tension d'alimentation VDD du circuit. Le transistor 103 de la cellule est ensuite rendu passant par application d'un signal de niveau haut sur la piste conductrice SL de la cellule. Après l'activation du transistor 103, la piste conductrice RBLT se décharge si le potentiel du noeud de stockage (point milieu entre les résistances R1 et R2) est à un niveau haut (transistor 105 passant), et reste sensiblement à son niveau de précharge si le potentiel du noeud de stockage est à un niveau bas (transistor 105 bloqué). La lecture du potentiel de la piste RBLT via un circuit de lecture non représenté, par exemple disposé en pied de colonne, permet de déterminer la valeur du bit de donnée stocké dans la cellule élémentaire.

De façon similaire à ce qui a été décrit en relation avec les figures 2, 3, 4, 5, 6 et 7, la mémoire de la figure 8 peut comprendre un circuit de contrôle (non représenté) adapté à commander la mémoire pour mettre en oeuvre des opérations de calcul. Pour cela, le circuit de contrôle est par exemple adapté à activer simultanément en lecture deux, ou un nombre supérieur à deux, de cellules élémentaires d'une même colonne du circuit, via les ports d'accès RPT de ces cellules, après avoir préchargé à un niveau haut la piste de sortie NL de la colonne.

Plus généralement, les modes de réalisation décrits peuvent être adaptés à tout type de cellule mémoire élémentaire comportant au moins un noeud de stockage d'un bit de donnée, et au moins un port de lecture comprenant un transistor de lecture relié par sa grille au noeud de stockage, et un transistor de sélection monté en série avec le transistor de lecture entre un noeud d'application d'un potentiel de référence de la cellule et une piste conductrice de sortie commune à toutes les cellules élémentaires de la même colonne de la mémoire.

Les modes de réalisation décrits s'appliquent de préférence à des cellules différentielles dont les deux ports de lecture sont commandables individuellement.

A titre de variante, les modes de réalisation décrits peuvent être adaptés à des cellules élémentaires comportant un nombre de ports de lecture supérieur à deux, ce qui a pour avantage d'augmenter le nombre et la complexité des opérations de calcul logiques et/ou arithmétiques pouvant être mises en oeuvre.

**Revendications**

1. Circuit mémoire adapté à mettre en oeuvre des opérations de calcul, ce circuit comportant :

   une pluralité de cellules mémoires élémentaires ($10_{i,j}$) agencées selon des lignes et des colonnes, chaque cellule comportant :

   - un premier noeud (BLTI) de stockage d'un bit de donnée,
   - un premier transistor de lecture (T3) relié par sa grille audit premier noeud de stockage (BLTI),
   - un premier transistor de sélection (T4) monté en série avec le premier transistor de lecture (T3) entre un premier noeud (VGNDT) d'application d'un potentiel de référence de la cellule et une première piste conductrice de sortie (RBLT) commune à toutes les cellules d'une même colonne du circuit, et
   - un premier transistor d'accès en écriture (T1) reliant le premier noeud (BLTI) de stockage à une première piste conductrice d'écriture (WBLT) commune à toutes les cellules d'une même colonne du circuit et distincte de la première piste conductrice de sortie (RBLT) de la colonne ;

   pour chaque colonne du circuit, un circuit de redirection (201) configurable pour, dans une première configuration, relier la première piste conductrice de sortie (RBLT) de la colonne à une première piste conductrice d'écriture (WBLT) du circuit ; et
   un circuit de contrôle (14) configuré pour activer simultanément les premiers transistors de sélection (T4) d'au moins deux cellules ($10_{i,j}$, $10_{i+1,j}$) d'une même colonne du circuit, pour lire sur la première piste conductrice de sortie (RBLT) de la colonne une valeur représentative du résultat d'une première opération logique ayant pour opérandes les données stockées dans lesdites au moins deux cellules ($10_{i,j}$, $10_{i+1,j}$), et pour réécrire dans la mémoire ledit résultat via le circuit de redirection (201) sans le faire transiter par des circuits externes,

dans lequel le circuit de contrôle (14) est cadencé par un signal d'horloge (CLK_EXT) et est adapté, à chaque cycle du signal d'horloge (CLK_EXT), à recevoir un signal d'instruction contenant :

- un signal de commande (OP) indiquant au circuit mémoire le type d'opération à effectuer ;
- un signal d'adresse de lecture (READ_ADDR) contenant les adresses des rangées contenant les opérandes de l'opération ; et
- un signal d'adresse d'écriture (WRITE ADDR) contenant l'adresse de réécriture du résultat de l'opération,

le circuit de contrôle (14) étant adapté à extraire du signal d'instruction les signaux de commande (OP), d'adresse de lecture (READ_ADDR) et d'adresse d'écriture (WRITE_ADDR), puis à successivement :

- commander l'activation en lecture des rangées contenant les opérandes de l'opération ; et
- commander la réécriture du résultat de l'opération dans la mémoire.

**2.** Circuit mémoire selon la revendication 1, dans lequel le circuit de redirection (201) est en outre configurable pour, dans une deuxième configuration, relier la première piste conductrice d'écriture (WBLT) de la colonne à un noeud (dcol_ext) d'application d'un signal de donnée externe.

**3.** Circuit mémoire selon la revendication 1 ou 2, dans lequel le circuit de redirection (201) comprend un multiplexeur.

**4.** Circuit mémoire selon l'une quelconque des revendications 1 à 3, comportant en outre, pour chaque colonne du circuit, un premier inverseur (16 ; 51) dont un noeud d'entrée est relié à la première piste conductrice de sortie (RBLT) de la colonne.

**5.** Circuit mémoire selon l'une quelconque des revendications 1 à 4, dans lequel chaque cellule élémentaire comporte en outre :

- un deuxième noeud (BLFI) de stockage d'un bit de donnée complémentaire du bit stocké sur le premier noeud de stockage (BLTI) de la cellule,
- un deuxième transistor de lecture (T5) relié par sa grille audit deuxième noeud de stockage (BLFI),
- un deuxième transistor de sélection (T6) monté en série avec le deuxième transistor de lecture (T5) entre un deuxième noeud (VGNDF) d'application d'un potentiel de référence de la cellule et une deuxième piste conductrice de sortie (RBLF) commune à toutes les cellules d'une même colonne du circuit, et
- un deuxième transistor d'accès en écriture (T2) reliant le deuxième noeud (BLFI) de stockage à une deuxième piste conductrice d'écriture (WBLF) commune à toutes les cellules d'une même colonne du circuit,

dans lequel, dans chaque colonne le circuit de redirection (201) est adapté à, dans la première configuration, relier la deuxième piste conductrice de sortie (RBLF) de la colonne à une première ou deuxième piste conductrice d'écriture (WBLT, WBLF) du circuit,

le circuit de contrôle (14) étant en outre configuré pour activer simultanément les deuxièmes transistors de sélection (T6) d'au moins deux cellules ($10_{i,j}$, $10_{i+1,j}$) d'une même colonne du circuit, pour lire sur la deuxième piste conductrice de sortie (RBLF) de la colonne une valeur représentative du résultat d'une deuxième opération logique ayant pour opérandes les données stockées dans lesdites au moins deux cellules ($10_{i,j}$, $10_{i+1,j}$), et pour réécrire dans la mémoire ledit résultat via le circuit de redirection (201) sans le faire transiter par des circuits externes.

**6.** Circuit mémoire selon la revendication 5, dans lequel le circuit de contrôle (14) est en outre configuré pour activer simultanément :

les premiers (T4) et deuxièmes (T6) transistors de sélection de deux cellules ($10_{i,j}$, $10_{i+1,j}$) d'une même colonne du circuit ; ou
le premier transistor de sélection (T4) d'une première cellule ($10_{i,j}$) du circuit et le deuxième transistor de sélection (T6) d'une deuxième cellule ($10_{i+1,j}$) de la même colonne.

**7.** Circuit mémoire selon la revendication 5 ou 6, comportant en outre, pour chaque colonne du circuit, un deuxième inverseur (18 ; 52) dont un noeud d'entrée est relié à la deuxième piste conductrice de sortie (RBLF) de la colonne.

**8.** Circuit mémoire selon l'une quelconque des revendications 5 à 7, comportant en outre, pour chaque colonne du circuit, un circuit logique (20 ; 500) dont une première entrée est reliée à la première piste conductrice de sortie (RBLT) de la colonne et dont une deuxième entrée est reliée à la deuxième piste conductrice de sortie (RBLF) de la colonne.

**9.** Circuit mémoire selon la revendication 8, dans lequel ledit circuit logique comporte une porte logique NON OU (20) dont une première entrée est reliée à la première piste conductrice de sortie (RBLT) de la colonne et dont une deuxième entrée est reliée à la deuxième piste conductrice de sortie (RBLF) de la colonne.

**10.** Circuit mémoire selon la revendication 9, comportant en outre, pour chaque colonne du circuit, une première porte logique NON ET (41) dont une première entrée est reliée à un noeud de sortie de la porte logique NON OU (20) de la colonne, et une deuxième porte logique NON ET (43) dont une première entrée est reliée à un noeud de sortie de la première porte logique NON ET (41) de la colonne et dont une deuxième entrée est reliée à la deuxième piste conductrice de sortie (RBLF) de la colonne.

**11.** Circuit mémoire selon la revendication 9, dans lequel, dans chaque colonne à l'exception de la première colonne du circuit, la première porte logique NON ET (41) a une deuxième entrée reliée à la deuxième piste conductrice de sortie (RBLF) d'une colonne de rang précédent du circuit.

**12.** Circuit mémoire selon l'une quelconque des revendications 5 à 11, comportant en outre, pour chaque colonne :

une première piste conductrice de référence interconnectant les premiers noeuds (VGNDT) d'application de potentiel de référence de la colonne ; et
une deuxième piste conductrice de référence interconnectant les deuxièmes noeuds (VGNDF) d'application de potentiel de référence de la colonne.

**13.** Circuit mémoire selon la revendication 12, comportant en outre, pour chaque colonne :

un premier transistor de référence (22) reliant la première piste conductrice de référence (VGNDT) à un noeud de référence (GND) ; et
un deuxième transistor de référence (24) reliant la deuxième piste conductrice de référence (VGNDF) audit noeud de référence (GND).

**14.** Circuit mémoire selon la revendication 12, comportant en outre, pour chaque colonne, une porte logique ET (31), une porte logique OU (33), et des troisième (35), quatrième (36), cinquième (37) et sixième (38) inverseurs, et dans lequel :

la porte logique ET (31) a une première entrée reliée à un noeud d'application d'un premier signal binaire de contrôle (VGNDHIGH) par l'intermédiaire du troisième inverseur (35), et une deuxième entrée reliée à un noeud d'application d'un deuxième signal binaire de contrôle (COMP_OP) par l'intermédiaire du quatrième inverseur (36) ;
la sortie du troisième inverseur (35) est reliée à la première piste conductrice de référence (VGNDT) de la colonne par l'intermédiaire du cinquième inverseur ;
la porte logique OU (33) a une première entrée reliée à la première piste conductrice de sortie (RBLT) de la colonne, et une deuxième entrée reliée à la sortie de la porte logique ET (31) ; et
la sortie de la porte logique OU (33) est reliée à la deuxième piste conductrice de référence (VGNDF) de la colonne par l'intermédiaire du sixième inverseur (38).

**15.** Circuit mémoire selon la revendication 8, dans lequel le circuit logique (500) comprend :

un premier multiplexeur (57) ayant une première entrée reliée à l'entrée du premier inverseur (51) et une deuxième entrée reliée à la sortie du premier inverseur (51) ;
un troisième inverseur (53) dont l'entrée est reliée à la sortie du premier multiplexeur (57) ;
une troisième porte NON ET (54) dont une première entrée est reliée à la sortie du premier multiplexeur (57) et dont une deuxième entrée est reliée à l'entrée du deuxième inverseur (52) ;
une quatrième porte NON ET (55) dont une première entrée est reliée à la sortie du troisième inverseur (53) et dont une deuxième entrée est reliée à la sortie du deuxième inverseur (52) ; et
une cinquième porte NON ET (56) dont une première entrée est reliée à la sortie de la troisième porte NON ET (54) et dont la sortie est reliée à la sortie de la quatrième porte NON ET (55) .

**16.** Circuit mémoire selon l'une quelconque des revendications 1 à 15, dans lequel lesdites cellules mémoires élémentaires sont des cellules mémoires volatiles de type SRAM.

**17.** Circuit mémoire selon l'une quelconque des revendications 1 à 15, dans lequel lesdites cellules mémoires élémentaires sont des cellules mémoires résistives non volatiles.

**Patentansprüche**

**1.** Speicherschaltung, die geeignet ist zum Implementieren von Berechnungsoperationen, wobei die Schaltung Folgendes aufweist:

eine Vielzahl von Elementarspeicherzellen (10i, j), die in Zeilen und Spalten angeordnet sind, wobei jede Zelle Folgendes aufweist:

einen ersten Datenbit-Speicherknoten (BLTI);

einen ersten Auslesetransistor (T3), der über sein Gatter mit dem ersten Speicherknoten (BLTI) verbunden ist,

einen ersten Auswahltransistor (T4), der mit dem ersten Auslesetransistor (T3) zwischen einem ersten Knoten (VGNDT) zum Anlegen eines Referenzpotentials der Zelle und einer ersten Leiterausgangsbahn (RBLT) in Reihe geschaltet ist, die allen Zellen derselben Spalte der Schaltung gemeinsam ist; und

einen ersten Schreibzugangstransistor (T1), der den ersten Datenbit-Speicherknoten (BLTI) mit einer ersten Leiterschreibbahn (WBLT) koppelt, die allen Zellen derselben Spalte der Schaltung gemeinsam ist und sich von der ersten Leiterausgangsbahn der Spalte (RBLT) unterscheidet;

für jede Spalte der Schaltung eine Umleitungsschaltung (201), die in einer ersten Konfiguration konfigurierbar ist zum Koppeln der ersten Leiterausgangsbahn der Spalte (RBLT) an eine erste Leiterschreibbahn (WBLT) der Schaltung; und

eine Steuerschaltung (14), die konfiguriert ist zum gleichzeitigen Aktivieren der ersten Auswahltransistoren (T4) von wenigstens zwei Zellen ($10_{i,j}$, $10_{i+1,j}$) derselben Spalte der Schaltung, und zum Auslesen von der ersten Ausgangsleiterbahn (RBLT) der Spalte eines Wertes, der für das Ergebnis einer ersten logischen Operation repräsentativ ist, deren Operanden die in den wenigstens zwei Zellen ($10_{i,j}$, $10_{i+1,j}$) gespeicherten Daten sind, und zum Zurückschreiben des Ergebnisses in den Speicher durch die Umleitungsschaltung (201) ohne externe Schaltkreise zu durchlaufen,

wobei die Steuerschaltung (14) durch ein Taktsignal (CLK_EXT) getaktet ist und konfiguriert ist, zu jedem Taktzyklus des Taktsignals (CLK_EXT) ein Instruktionssignal zu empfangen, das Folgendes aufweist:

ein Befehlssignal (OP), das dem Speicher den Operationstyp, der ausgeführt werden soll, anzeigt;

ein Ausleseadresssignal (READ_ADDR), das die Adressen der Zeilen enthält, die die Operanden der Operation enthält; und

ein Schreibadresssignal (WRITE_ADDR), das die Adresse zum Zurückschreiben des Ergebnisses der Operation enthält,

wobei die Steuerschaltung (14) konfiguriert ist zum Extrahieren des Befehls (OP), der Ausleseadress- (READ_ADDR) und der Schreibadress- (WRITE_ADDR) Signale aus dem Instruktionssignal, und dann aufeinanderfolgend:

Befehlen der Aktivierung in den Auslesemodus der Reihen, die die Operanden der Operationen enthalten; und

Befehlen des Zurückschreibens des Ergebnisses der Operation in die Speicherschaltung.

2. Speicherschaltung nach Anspruch 1, wobei die Umleitungsschaltung (201) ferner konfigurierbar ist, um in einer zweiten Konfiguration die erste Leiterschreibbahn (WBLT) der Spalte mit einem Knoten (dcol_ext) zum Anlegen eines externen Datensignals zu koppeln.

3. Speicherschaltung nach Anspruch 1 oder 2, wobei die Umleitungsschaltung (201) einen Multiplexer aufweist.

4. Speicherschaltung nach einem der Ansprüche 1 bis 3, die ferner für jede Spalte der Schaltung einen ersten Inverter (16; 51) mit einem Eingangsknoten aufweist, der mit der ersten Leiterausgangsbahn (RBLT) der Spalte verbunden ist.

5. Speicherschaltung nach einem der Ansprüche 1 bis 4, wobei jede Elementarzelle ferner Folgendes aufweist:

einen zweiten Knoten (BLFI) zum Speichern eines Datenbits, das komplementär zu dem auf dem ersten Speicherknoten (BLTI) der Zelle gespeicherten Bits ist,

einen zweiten Auslesetransistor (T5), der über sein Gatter mit dem zweiten Speicherknoten (BLFI) verbunden ist,

einen zweiten Auswahltransistor (T6), der in Reihe mit dem zweiten Auslesetransistor (T5) zwischen einem zweiten Knoten (VGNDF) zum Anlegen eines Referenzpotentials der Zelle und einer zweiten Leiterausgangsbahn (RBLF), geschaltet ist, die allen Zellen derselben Spalte der Schaltung gemeinsam ist, und

einen zweiten Schreibzugangstransistor (T2), der den zweiten Datenbitspeicherknoten (BLFI) mit einer zweiten Leiterschreibbahn (WBLF) koppelt, die allen Zellen derselben Spalte der Schaltung gemeinsam ist,

wobei in jeder Spalte der Schaltung die Umleitungsschaltung (201) konfiguriert ist, um in der ersten Konfiguration die zweite Leiterausgangsbahn (RBLF) der Spalte mit einer ersten oder zweiten Leiterschreibbahn (WBLT, WBLF) der Schaltung zu koppeln,
die Steuerschaltung (14) ferner konfiguriert ist zum gleichzeitigen Aktivieren der zweiten Auswahltransistoren (T6) von wenigstens zwei Zellen ($10_{i,j}$, $10_{i+i,j}$) derselben Spalte der Schaltung und zum Auslesen aus der zweiten Leiterausgangsbahn (RBLF) der Spalte eines Wertes, der für das Ergebnis einer zweiten logischen Operation repräsentativ ist, deren Operanden die in den wenigstens zwei Zellen ($10_{i,j}$, $10_{i+1,j}$) gespeicherten Daten sind, und zum Zurückschreiben des Ergebnisses in den Speicher über die Umleitungsschaltung (201) ohne externe Schaltkreise zu durchlaufen.

6.  Speicherschaltung nach Anspruch 5, wobei die Steuerschaltung (14) ferner konfiguriert ist zum gleichzeitigen Aktivieren von:

    den ersten (T4) und zweiten (T6) Auswahltransistoren der zwei Zellen ($10_{i,j}$, $10_{i+1,j}$) der gleichen Spalte der Schaltung; oder
    dem ersten Auswahltransistor (T4) einer ersten Schaltungszelle ($10_{i,j}$) und dem zweiten Auswahltransistor (T6) einer zweiten Zelle ($10_{i+1,j}$) derselben Spalte.

7.  Speicherschaltung nach Anspruch 5 oder 6, die ferner für jede Spalte der Schaltung einen zweiten Inverter (18; 52) mit einem Eingangsknoten aufweist, der mit der zweiten Leiterausgangsbahn (RBLF) der Spalte verbunden ist.

8.  Speicherschaltung nach einem der Ansprüche 5 bis 7, die ferner für jede Spalte der Schaltung eine Logikschaltung (20; 500) mit einem ersten Eingang aufweist, der mit der ersten Leiterausgangsbahn (RBLT) der Spalte verbunden ist, und mit einem zweiten Eingang, der mit der zweiten Leiterausgangsbahn (RBLF) der Spalte verbunden ist.

9.  Speicherschaltung nach Anspruch 8, wobei die Logikschaltung ein NOR-Logikgatter (20) aufweist, dessen erster Eingang mit der ersten Ausgangsleiterbahn (RBLT) der Spalte verbunden ist, und dessen zweiter Eingang mit der zweiten Leiterausgangsbahn (RBLF) der Spalte verbunden ist.

10. Speicherschaltung nach Anspruch 9, die ferner für jede Spalte der Schaltung ein erstes NAND-Logikgatter (41) mit einem ersten Eingang aufweist, der mit einem Ausgangsknoten des NOR-Logikgatters (20) der Spalte verbunden ist, und ein zweites NAND-Logikgatter (43), dessen erster Eingang mit einem Ausgangsknoten des ersten NAND-Logikgatters (41) der Spalte verbunden ist, und dessen zweiter Eingang mit der zweiten Leiterausgangsbahn (RBLF) der Spalte verbunden ist.

11. Speicherschaltung nach Anspruch 9, wobei in jeder Spalte außer der ersten Spalte der Schaltung das erste NAND-Logikgatter (41) einen zweiten Eingang aufweist, der mit der zweiten Leiterausgangsbahn (RBLF) einer Spalte mit dem vorherigen Rang der Schaltung verbunden ist.

12. Speicherschaltung nach einem der Ansprüche 5 bis 11, die ferner für jede Spalte Folgendes aufweist:

    eine erste Leiterreferenzbahn, die die ersten Knoten (VGNDT) des Anlegens eines Referenzpotentials der Spalte miteinander verbindet; und
    eine zweite Leiterreferenzbahn, die die zweiten Knoten (VGNDF) des Anlegens eines Referenzpotentials der Spalte miteinander verbindet.

13. Speicherschaltung nach Anspruch 12, die ferner für jede Spalte Folgendes aufweist:

    einen ersten Referenztransistor (22), der die erste Referenzleiterbahn (VGNDT) mit einem Referenzknoten (GND) verbindet; und
    einen zweiten Referenztransistor (24), der die zweite Referenzleiterbahn (VGNDF) mit dem Referenzknoten (GND) verbindet.

14. Speicherschaltung nach Anspruch 12, die ferner für jede Spalte ein AND-Logikgatter (31), ein OR-Gatter (33) und einen dritten (35), vierten (36), fünften (37) und sechsten (38) Inverter aufweist, und wobei:

    das AND-Logikgatter (31) einen ersten Eingang hat, der über den dritten Inverter (35) mit einem Knoten des Anlegens eines ersten binären Steuersignals (VGNDHIGH) verbunden ist, und einen zweiten Eingang, der über den vierten Inverter (36) mit einem Knoten des Anlegens eines zweiten binären Steuersignals (COMP_OP) verbunden ist;
    der Ausgang des dritten Inverters (35) über den fünften Inverter mit der ersten Referenzleiterbahn (VGNDT) der Spalte verbunden ist;
    das OR-Logikgatter (33) einen ersten Eingang hat, der mit der ersten Leiterausgangsbahn (RBLT) der Spalte verbunden ist, und einen zweiten Eingang, der mit dem Ausgang des AND-Logikgatters (31) verbunden ist; und
    der Ausgang des OR-Logikgatters (33) über den sechsten Inverter (38) mit der zweiten Leiterreferenzbahn (VGNDF) der Spalte verbunden ist.

15. Speicherschaltung nach Anspruch 8, wobei die Logikschaltung (500) Folgendes aufweist:

    einen ersten Multiplexer (57) mit einem ersten Eingang, der mit dem Eingang des ersten Inverters (51) verbunden ist, und einem zweiten Eingang, der mit dem Ausgang des ersten Inverters (51) verbunden ist;

einen dritten Inverter (53), dessen Eingang mit dem Ausgang des ersten Multiplexers (57) verbunden ist;

ein drittes NAND-Gatter (54), dessen erster Eingang mit dem Ausgang des ersten Multiplexers (57) verbunden ist und dessen zweiter Eingang mit dem Eingang des zweiten Inverters (52) verbunden ist;

ein viertes NAND-Gatter (55) mit einem ersten Eingang, der mit dem Ausgang des dritten Inverters (53) verbunden ist, und dessen zweiter Eingang mit dem Eingang des zweiten Inverters (52) verbunden ist; und

ein fünftes NAND-Gatter (56) mit einem ersten Eingang, der mit dem Ausgang des dritten NAND-Gatters (54) verbunden ist und dessen Ausgang mit dem Ausgang des vierten NAND-Gatters (55) verbunden ist.

16. Speicherschaltung nach einem der Ansprüche 1 bis 15, wobei die elementaren Speicherzellen flüchtige SRAM-Speicherzellen sind.

17. Speicherschaltung nach einem der Ansprüche 1 bis 15, wobei die elementaren Speicherzellen nichtflüchtige resistive Speicherzellen sind.

**Claims**

1. A memory circuit capable of implementing calculation operations, the circuit comprising:

a plurality of elementary memory cells ($10_{i,j}$) arranged in rows and in columns, each cell comprising:

- a first data bit storage node (BLTI),
- a first read-out transistor (T3) connected by its gate to said first storage node (BLTI),
- a first selection transistor (T4) series-connected with the first read-out transistor (T3) between a first node (VGNDT) of application of a reference potential of the cell and a first conductive output track (RBLT) common to all the cells of a same column of the circuit, and
- a first write access transistor (T1) coupling the first data bit storage node (BLTI) to a first conductive write track (WBLT) common to all the cells of a same column of the circuit and distinct from the first conductive output track of the column (RBLT);

for each column of the circuit, a redirection circuit (201) configurable to, in a first configuration, couple the first conductive output track of the column (RBLT) to a first conductive write track (WBLT) of the circuit; and

a control circuit (14) configured to simultaneously activate the first selection transistors (T4) of at least two cells ($10_{i,j}$, $10_{i+1,j}$) of a same column of the circuit, and to read from the first conductive output track (RBLT) of the column a value representative of the result of a first logic operation having as operands the data stored in said at least two cells ($10_{i,j}$, $10_{i+1,j}$), and to write back into the memory said result via the redirection circuit (201) without having it transit through external circuits,

wherein the control circuit (14) is clocked by a clock signal (CLK_EXT) and is configured to, at each clock cycle of the clock signal (CLK EXT), receiving an instruction signal comprising:

- a command signal (OP) indicating to the memory the type of operation to be performed;
- a read address signal (READ_ADDR) containing the addresses of the rows containing the operands of the operation; and
- a write address signal (WRITE_ADDR) containing the address for writing back the result of the operation,

the control circuit (14) being configured to extract from the instruction signal the command (OP), read address (READ_ADDR) and write address (WRITE_ADDR) signals, and then, successively:

- command the activation into read mode of the rows containing the operands of the operation; and
- command the writing back of the result of the operation into the memory circuit.

2. The memory circuit of claim 1, wherein the redirection circuit (201) is further configurable to, in a second configuration, couple the first conductive write track (WBLT) of the column to a node (dcol_ext) of application of an external data signal.

3. The memory circuit of claim 1 or 2, wherein the redirection circuit (201) comprises a multiplexer.

4. The memory circuit of any of claims 1 to 3, further comprising, for each column of the circuit, a first inverter (16; 51) having an input node connected to the first conductive output track (RBLT) of the column.

5. The memory circuit of any of claims 1 to 4, wherein each elementary cell further comprises:

- a second node (BLFI) for storing a data bit complementary to the bit stored on the first storage node (BLTI) of the cell,
- a second read-out transistor (T5) connected by its gate to said second storage node (BLFI),
- a second selection transistor (T6) series-connected with the second read-out transistor (T5) between a second node (VGNDF) of application of a reference potential of the cell and a second conductive output track (RBLF) common to all the cells of a same column of the circuit, and
- a second write access transistor (T2) coupling the second data bit storage node (BLFI) to a second conductive write track (WBLF) common to all the cells of a same column of the circuit,

wherein, in each column of the circuit, the redirection circuit (201) is configurable to, in the first configuration, couple the second conductive output track (RBLF) of the column to a first or second conductive write track (WBLT, WBLF) of the circuit, the control circuit (14) being further configured to simultaneously activate the second selection transistors (T6) of at least two cells ($10_{i,j}$, $10_{i+1,j}$) of a same column of the circuit, and to read from the second conductive output track (RBLF) of the column a value representative of the result of a second logic operation having as operands the data stored in said at least two cells ($10_{i,j}$, $10_{i+1,j}$), and to write back into the memory said result via the redirection circuit (201) without having it transit through external circuits.

6. The memory circuit of claim 5, wherein the control circuit (14) is further configured to simultaneously activate:

the first (T4) and second (T6) selection transistors of two cells ($10_{i,j}$, $10_{i+1,j}$) of a same column of the circuit; or
the first selection transistor (T4) of a first circuit cell ($10_{i,j}$) and the second selection transistor (T6) of a second cell ($10_{i+1,j}$) of the same column.

7. The memory circuit of claim 5 or 6, further comprising, for each column of the circuit, a second inverter (18; 52) having an input node connected to the second conductive output track (RBLF) of the column.

8. The memory circuit of any of claims 5 to 7, further comprising, for each column of the circuit, a logic circuit (20; 500) having a first input connected to the first conductive output track (RBLT) of the column and having a second input connected to the second conductive output track (RBLF) of the column.

9. The memory circuit of claim 8, wherein said logic circuit comprises a NOR logic gate (20) having a first input connected to the first conductive output track (RBLT) of the column and having a second input connected to the second conductive output track (RBLF) of the column.

10. The memory circuit of claim 9, further comprising, for each column of the circuit, a first NAND logic gate (41) having a first input connected to an output node of the NOR logic gate (20) of the column, and a second NAND logic gate (43) having a first input connected to an output node of the first NAND logic gate (41) of the column and having a second input connected to the second conductive output track (RBLF) of the column.

11. The memory circuit of claim 9, wherein, in each column except for the first column of the circuit, the first NAND logic gate (41) has a second input connected to the second conductive output track (RBLF) of a column of previous rank of the circuit.

12. The memory circuit of any of claims 5 to 11, further comprising, for each column:

a first conductive reference track interconnecting the first nodes (VGNDT) of application of a reference potential of the column; and
a second conductive reference track interconnecting the second nodes (VGNDF) of application of a reference potential of the column.

13. The memory circuit of claim 12, further comprising, for each column:

a first reference transistor (22) connecting the first reference conductive track (VGNDT) to a reference node (GND); and
a second reference transistor (24) connecting the second reference conductive track (VGNDF) to said reference node (GND).

14. The memory circuit of claim 12, further comprising, for each column, an AND logic gate (31), an OR logic gate (33), and third (35), fourth (36), fifth (37), and sixth (38) inverters, and wherein:

the AND logic gate (31) has a first input connected to a node of application of a first binary control signal (VGNDHIGH) via the third inverter (35), and a second input connected to a node of application of a second binary control signal (COMP_OP) via the fourth inverter (36);
the output of the third inverter (35) is connected to the first conductive reference track (VGNDT) of the column via the fifth inverter;
the OR logic gate (33) has a first input connected to the first conductive output track (RBLT) of the column, and a second input connected to the output of the AND logic gate (31); and
the output of OR logic gate (33) is connected to
the second conductive reference track (VGNDF)
of the column via the sixth inverter (38).

15. The memory circuit of claim 8, wherein the logic circuit (500) comprises:

a first multiplexer (57) having a first input connected to the input of the first inverter (51) and a second input connected to the output of the first inverter (51);
a third inverter (53) having its input connected to the output of the first multiplexer (57);
a third NAND gate (54) having a first input connected to the output of the first multiplexer (57) and having a second input connected to the input of the second inverter (52);
a fourth NAND gate (55) having a first input connected to the output of the third inverter (53) and having a second input connected to the input of the second inverter (52); and
a fifth NAND gate (56) having a first input connected to the output of the third NAND gate (54) and having its output connected to the output of the fourth NAND gate (55).

16. The memory circuit of any of claims 1 to 15, wherein said elementary memory cells are SRAM-type volatile memory cells.

17. The memory circuit of any of claims 1 to 15, wherein said elementary memory cells are non-volatile resistive memory cells.

Fig 1

Fig 2

EP 3 252 774 B1

Fig 3

24

Fig 4

Fig 5

Fig 6

Fig 7

Fig 8

Fig 9

**EP 3 252 774 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009141537 A
- US 2016125919 A